# EUROPEAN PATENT APPLICATION

(11) **EP 4 687 404 A1**
(43) Date of publication of application: **04.02.2026**
(21) Application number: 25185373.5
(22) Date of filing: 26.06.2025
(51) Int. Cl.: H10K 59/121, H10K 59/131, H10K 59/126

(54) **DISPLAY DEVICE**

(30) Priority: 29.07.2024 KR 20240100458
(71) Applicant: LG Display Co., Ltd., Seoul, 07336 (KR)
(72) Inventor: HAN, Seungjin, 10845 Paju-si (KR); KWON, Dhang, 10845 Paju-si (KR); CHO, HangSup, 10845 Paju-si (KR); OH, KyungHwan, 10845 Paju-si (KR); KIM, Jaehyeong, 10845 Paju-si (KR)
(74) Representative: Ter Meer Steinmeister & Partner

(57) **Abstract**

Embodiments of the disclosure relate to a display device. The display device includes a substrate (210), a metal pattern (820) disposed in a non-transmissive area (NTA2) and including a transparent material, a first data line (DL) disposed on the substrate (210) and disposed over the non-transmissive area (NTA2) and at least one of a plurality of transmissive areas (TA2), and a first active layer (ACT1) disposed on the metal pattern (820) and overlapping the metal pattern (820), thereby enhancing the transmittance of the optical area (OA2).

## Description

### CROSS-REFERENCE TO RELATED APPLICATION

This application claims priority from Republic of Korea Patent Application No. 10-2024-0100458, filed on July 29, 2024.

### TECHNICAL FIELD

Embodiments of the disclosure relate to a display device.

### BACKGROUND

As the information society develops, demand for display devices for displaying images is increasing in various forms. Various display devices, such as liquid crystal display devices and organic light emitting display devices, are being utilized in recent years.

A display area is an area where an image is displayed. The display area may include a normal display area and an optical area. The display device may include an optical device disposed in the optical area. As the transmittance of the optical area increases, the sensing capability of the optical device may be enhanced.

### SUMMARY

Embodiments of the disclosure may increase the transmittance of the optical area through a display panel including a transparent metal.

Embodiments of the disclosure may increase the transmittance of a non-transmissive area through a display panel including a transparent metal.

Embodiments of the disclosure may increase the transmittance of a transmissive area through a display panel including a transparent metal.

Embodiments of the disclosure may provide a display device capable of lower power consumption by increasing the transmittance of an optical area.

One or more of the above-identified objects are solved by the features of the independent claim.

According to an aspect of the invention, there is provided a display device, comprising: a substrate including a display area configured to display an image, the display area including a normal area and an optical area including a plurality of transmissive areas, and the optical area further including a non-transmissive area (that is) outside the plurality of transmissive areas; a metal pattern (disposed) on the substrate, (disposed) in the non-transmissive area; a first data line (disposed) on the substrate, the first data line extending over the non-transmissive area and at least one of the plurality of transmissive areas; and a first active layer (disposed) on the metal pattern and overlapping the metal pattern. The metal pattern may include a transparent material.

According to another aspect of the invention, there is provided a display device comprising: a substrate including a display area configured to display an image, the display area including a normal area and an optical area including a plurality of transmissive areas, and the optical area further including a non-transmissive area (that is) outside the plurality of transmissive areas; a first subpixel (positioned) on the substrate, (disposed) in the non-transmissive area, and including a first transistor; a second subpixel (positioned) on the substrate, (disposed) in the non-transmissive area, and including a second transistor; a first data line connected to the first subpixel, the first data line extending over the non-transmissive area and at least one of the plurality of transmissive areas; a second data line connected to the second subpixel, the second data line extending over the non-transmissive area and at least one of the plurality of transmissive areas; and a metal pattern (disposed) in the non-transmissive area, positioned under the first transistor and the second transistor, overlapping (for example, all of) at least a portion of the first transistor and at least a portion of the second transistor, and having a line shape. The metal pattern may overlap all of the first transistor and the second transistor.

According to embodiments of the disclosure, it is possible to increase the transmittance of the optical area through a display panel including a transparent metal.

According to embodiments of the disclosure, it is possible to increase the transmittance of a non-transmissive area through a display panel including a transparent metal.

According to an embodiment of the disclosure, it is possible to increase the transmittance of a transmissive area through a display panel including a transparent metal.

According to an embodiment of the disclosure, it is possible to provide a display device capable of lower power consumption by increasing the transmittance of an optical area.

Further embodiments of the disclosure described herein are briefly described below. Each of the above-described embodiments of the disclosure may include one or more of the features described below.

The normal area may be an area of the display area. The optical area may be an area of the display area. The normal area is different from the optical area. The normal area may be different from the optical area in that only the optical area includes the plurality of transmissive areas and/or in that the normal area does not include transmissive areas. The normal area may be non-transmissive. The normal area may be a non-transmissive area. The normal area and one or more optical areas included in the display area may be areas capable of displaying an image.

The display device may comprise a substrate including a display area where an image is displayed. The display device may comprise a substrate including a display area configured to display an image. The display area may include a normal area and an optical area including a plurality of transmissive areas. The optical area may further include a non-transmissive area outside the plurality of transmissive areas. The display device may comprise a metal pattern disposed on the substrate. The metal pattern may be disposed in the non-transmissive area. The metal pattern may include a transparent material. The metal pattern may be transparent. The display device may comprise a first data line disposed on the substrate. The first data line may be disposed over (or may extend over) the non-transmissive area and at least one of the plurality of transmissive areas. The display device may comprise a first active layer disposed on the metal pattern (in particular, disposed above the metal pattern) and/or overlapping the metal pattern. That is, at least a portion of the first active layer may overlap the metal pattern.

The first data line may extend from a first transmissive area of the plurality of transmissive areas to the non-transmissive area. A portion, positioned in the first transmissive area, of the first data line may include a transparent material, and a portion, positioned in the non-transmissive area, of the first data line may include the transparent material or an opaque material.

The first data line may include a first line portion (disposed) on the/a same layer as the metal pattern. The first line portion may extend from a first transmissive area of the plurality of transmissive areas to the non-transmissive area. The first line portion may include the transparent material. The first data line may include a second line portion disposed on the metal pattern. The second line portion may be electrically connected to the first line portion. The second line portion may include an opaque material. The first data line may include a third line portion (disposed) on the same layer as the metal pattern. The third line portion may extend from the non-transmissive area to a second transmissive area of the plurality of transmissive areas. The third line portion may be electrically connected to the second line portion. The third line portion may include the transparent material.

The display device may further comprise an optical device (disposed) under the substrate. The optical device may have at least a portion (disposed) in at least one transmissive area of the plurality of transmissive areas. The optical device may have at least a portion (disposed) in the first transmissive area. The first line portion and the third line portion may overlap the optical device.

The display device may comprise the/an optical device (disposed) under the substrate. The optical device may have at least a portion (disposed) in the non-transmissive area. The metal pattern may overlap the optical device.

The metal pattern may include a first island metal. The first island metal may be (disposed) on the same layer as the first data line. The metal pattern may include a second island metal. The second island metal may be disposed on the same layer as the first data line. The second island metal may be (disposed to be) spaced apart from the first island metal with the first data line interposed therebetween.

The first data line may (be disposed to) extend from the non-transmissive area to a transmissive area from (or: of) the plurality of transmissive areas. The first data line may (be disposed to) extend from the non-transmissive area to the first transmissive area. The first data line may (be disposed to) pass through an area between the first island metal and the second island metal. The first data line may include the transparent material.

The first data line may include a transparent line portion. The first data line may (be disposed to) pass through an area between the first island metal and the second island metal. The transparent line portion may (be disposed to) pass through an area between the first island metal and the second island metal. The transparent line portion may (be disposed to) pass through an area between the first island metal and the second island metal in a first transmissive area of the plurality of transmissive areas. The transparent line portion may be disposed in a first transmissive area of the plurality of transmissive areas. The transparent line portion may include the transparent material. The first data line may include an opaque line portion (disposed) in the non-transmissive area. The opaque line portion may be electrically connected to the transparent line portion. The opaque line portion may include an opaque material.

The transparent line portion may extend from the first transmissive area to a portion of the non-transmissive area.

The metal pattern and the first data line may (be disposed to) be spaced apart from each other. The metal pattern and the first data line may (be disposed to) extend in the/a same direction. In particular, the metal pattern may have a main extension that extends in a same direction as a main extension of the first data line.

The metal pattern may (be disposed to) extend in a first direction and the first data line may (be disposed to) extend in a second direction (that is) different from the first direction. In particular, the metal pattern may have a main extension that extends in a first direction, and the first data line may have a main extension that extends in a second direction different from the first direction. The metal pattern may (be disposed to) overlap the first data line. Both or either of the metal pattern and the first data line may include a transparent material.

An amount of electric charges under the metal pattern may be larger than an amount of electric charges over/above the metal pattern. In other words, an upper electric charge of the metal pattern may be smaller than a lower electric charge of the metal pattern. In particular, when electric charges are accumulated in a contact portion between the substrate and a first buffer layer disposed under the first active layer, an amount of electric charges under the metal pattern may be larger than an amount of electric charges above the metal pattern. In particular, when electric charges are accumulated below a component disposed under the metal pattern, an amount of electric charges under the metal pattern may be larger than an amount of electric charges above the metal pattern. The metal pattern may be disposed between the substrate and the first buffer layer.

The display device may further comprise a second active layer including a material different from a material included in the first active layer. An area of the first active layer may be larger than an area of the second active layer.

The display device may comprise a substrate including a display area where an image is displayed. The display device may comprise a substrate including a display area configured to display an image. The display area may include a normal area and an optical area. The optical area may include a plurality of transmissive areas. The optical area may further include a non-transmissive area outside the plurality of transmissive areas. The display device may comprise a first subpixel positioned on the substrate. The first subpixel may be disposed in the non-transmissive area. The first subpixel may include a first transistor. The display device may comprise a second subpixel positioned on the substrate. The second subpixel may be disposed in the non-transmissive area. The second subpixel may include a second transistor. The display device may comprise a first data line connected to the first subpixel. The first data line may be disposed over (or may extend over) the non-transmissive area and at least one of the plurality of transmissive areas. The display device may comprise a second data line connected to the second subpixel. The second data line may be disposed over (or may extend over) the non-transmissive area and at least one of the plurality of transmissive areas. The display device may comprise a metal pattern disposed in the non-transmissive area. The metal pattern may be positioned under the first transistor and the second transistor. The metal pattern may overlap all of at least a portion of the first transistor and at least a portion of the second transistor. The first transistor may comprise a/the first active layer. The first active layer may overlap the metal pattern.

The metal pattern may have a line shape, in particular, a curved line shape, a line shape including a pattern, a line shape pattern (such as a line the shape of which has or follows a pattern), or, in particular, a line shape that repeats a (predetermined) pattern. The pattern may be a zigzag pattern or meandering pattern.

The metal pattern may include a transparent material.

The metal pattern may extend to the normal area.

The display device may further comprise a further metal pattern (disposed) on the/a same layer as the (first-mentioned) metal pattern, in the normal area. The further metal pattern may be disposed in the normal area. The further metal pattern may include an opaque material.

The (first-mentioned) metal pattern may have a curved line shape.

In embodiment, the metal pattern may have either a line shape without a broken point or a line shape with at least one broken point. Herein, a broken point may also be termed a disconnection point. That is, the broken point or disconnection point may interrupt the metal pattern.

The first data line and the second data line may include the/a same transparent material as the metal pattern.

The metal pattern may cross the first data line and the second data line in a first area and a second area, respectively. The first data line may include a first opaque line portion disposed in the first area and/or a first transparent line portion disposed in an area other than the first area. The first opaque line portion and the first transparent line portion may be electrically connected to each other. The first opaque line portion and the first transparent line portion may be electrically connected to each other through a first contact hole in an insulation layer (disposed) between the first opaque line portion and the first transparent line portion. The second data line may include a second opaque line portion (disposed) in the second area and/or a second transparent line portion (disposed) in an area other than the second area. The second opaque line portion and the second transparent line portion may be electrically connected to each other. The second opaque line portion and the second transparent line portion may be electrically connected to each other through a second contact hole in the insulation layer (disposed) between the second opaque line portion and the second transparent line portion.

The "metal pattern" mentioned above may also be termed a first metal pattern. The "further metal pattern" mentioned above may also be termed a second metal pattern. The "further metal pattern" mentioned above may be a shield metal, in particular, a first shield metal.

A plurality of subpixels and signal lines for driving the plurality of subpixels may be disposed in the display area. The optical device may include one or more of a capture device, such as a camera (image sensor), and a detection sensor, such as a proximity sensor and an illuminance sensor. The one or more optical areas may have both an image display structure and a light transmission structure. The one or more optical device may be positioned behind (below, opposite to the viewing surface) the display panel to receive the light transmitted through the display panel. The one or more optical areas may have a transmittance higher than or equal to a certain level, and the normal area may have no light transmittance or a lower transmittance less than the certain level. The display device according to embodiments of the disclosure may be a liquid crystal display device or a self-emission display device in which the display panel emits light by itself. The plurality of signal lines may include a plurality of data lines for supplying data signals and a plurality of gate lines for supplying gate signals. The entire normal area may correspond to a non-transmissive area.

### BRIEF DESCRIPTION OF DRAWINGS

The above and other objects, features, and advantages of the disclosure will be more clearly understood from the following detailed description, taken in conjunction with the accompanying drawings, in which:
FIGS. 1A, 1B, and 1C illustrate a display device according to embodiments of the disclosure;
FIG. 2 is a view illustrating a system configuration of a display device according to embodiments of the disclosure;
FIG. 3 illustrates a display panel according to an embodiment of the disclosure;
FIG. 4 illustrates signal lines disposed on a display panel according to embodiments of the disclosure;
FIG. 5 illustrates a normal area, a first optical area, and a second optical area in a display panel according to embodiments of the disclosure;
FIG. 6 is a cross-sectional view of area A-B of the normal area of FIG. 5 according to embodiments of the disclosure;
FIG. 7 is a view illustrating a pixel array layer and a lower metal layer according to embodiments of the disclosure;
FIG. 8 is a plan view illustrating a partial area of an optical area where a metal pattern is disposed according to embodiments of the disclosure;
FIG. 9 is a cross-sectional view of area C-D of FIG. 8 according to embodiments of the disclosure;
FIG. 10 is a cross-sectional view of area E-F of FIG. 8 according to embodiments of the disclosure;
FIG. 11 is a cross-sectional view of area G-H of FIG. 8 according to embodiments of the disclosure;
FIG. 12 is a plan view illustrating a partial area of an optical area where a metal pattern is disposed according to embodiments of the disclosure;
FIG. 13 is a cross-sectional view of area I-J of FIG. 12 according to embodiments of the disclosure;
FIG. 14 is a cross-sectional view of area K-L of FIG. 12 according to embodiments of the disclosure;
FIG. 15 is a plan view illustrating an optical area where a metal pattern is disposed according to embodiments of the disclosure; and
FIGS. 16 and 17 are plan views illustrating an optical area where a metal pattern is disposed according to embodiments of the disclosure.

### DETAILED DESCRIPTION

In the following description of examples or embodiments of the disclosure, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the disclosure, detailed descriptions of well-known functions and components incorporated herein will be omitted when it is determined that the description may make the subject matter in some embodiments of the disclosure rather unclear. The terms such as "including", "having", "containing", "constituting" "make up of", and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the disclosure. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When time relative terms, such as "after," "subsequent to," "next," "before," and the like, are used to describe processes or operations of elements or configurations, or flows or steps in operating, processing, manufacturing methods, these terms may be used to describe non-consecutive or non-sequential processes or operations unless the term "directly" or "immediately" is used together.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

Hereinafter, various embodiments of the disclosure are described in detail with reference to the accompanying drawings.

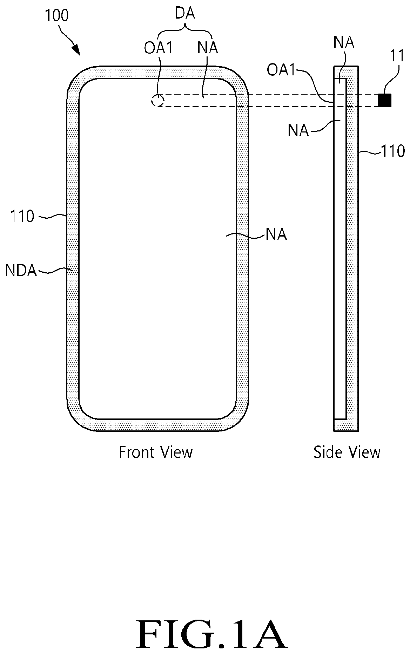

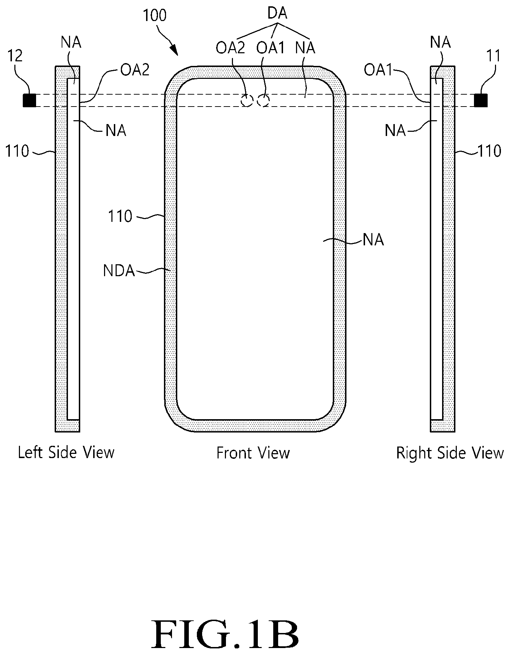

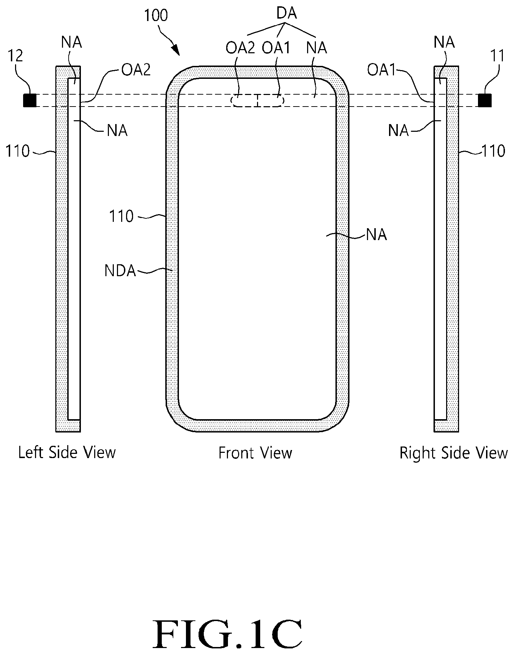

FIGS. 1A, 1B, and 1C illustrate a display device 100 according to embodiments of the disclosure.

Referring to FIGS. 1A, 1B, and 1C, a display device 100 according to embodiments of the disclosure may include a display panel 110 for displaying images and one or more electronic devices 11 and 12.

The display panel 110 may include a display area DA in which images are displayed and a non-display area NDA in which no image is displayed. A plurality of subpixels and various signal lines for driving the plurality of subpixels may be disposed in the display area DA. The non-display area NDA may be an area outside the display area DA. Various signal lines may be disposed in the non-display area NDA, and various driving circuits may be connected to the non-display area NDA. The non-display area NDA may be bent to be invisible from the front or may be covered by a case (not shown). The non-display area NDA is also referred to as a bezel or a bezel area.

The display device 100 according to embodiments of the disclosure may include one or more electronic devices 11 and 12 positioned on a lower portion (side opposite to the viewing surface) of the display panel 110. Here, the one or more electronic devices 11 and 12 may be provided separately from the display panel 110.

The one or more electronic devices 11 and 12 may be devices that receive light passing through the display panel 110 and perform a predetermined operation based on the received light.

For example, the one or more electronic devices 11 and 12 may include one or more of a capture device, such as a camera (image sensor), and a detection sensor, such as a proximity sensor and an illuminance sensor. For example, the detection sensor may be an infrared sensor.

The light required for the operation of the one or more electronic devices 11 and 12 may enter the front surface (viewing surface) of the display panel 110 and pass through the display panel 110 to one or more electronic devices 11 and 12 positioned under the display panel 110 (opposite to the viewing surface). For example, the light required for the operation of the one or more electronic devices 11 and 12 and passing through the display panel 110 may include one or more of visible light, infrared light, and ultraviolet light.

Referring to FIGS. 1A, 1B, and 1C, in the display panel 110 according to embodiments of the disclosure, the display area DA may include a normal area NA and one or more optical areas OA1 and OA2. The one or more optical areas OA1 and OA2 may be areas overlapping the one or more electronic devices 11 and 12.

According to the example of FIG. 1A, the display area DA may include the normal area NA and the first optical area OA1. At least a portion of the first optical area OA1 may overlap the first electronic device 11.

According to the example of FIG. 1B, the display area DA may include a normal area NA, a first optical area OA1, and a second optical area OA2. In the example of FIG. 1B, the normal area NA may be present between the first optical area OA1 and the second optical area OA2. At least a portion of the first optical area OA1 may overlap the first electronic device 11, and at least a portion of the second optical area OA2 may overlap the second electronic device 12.

According to the example of FIG. 1C, the display area DA may include a normal area NA, a first optical area OA1, and a second optical area OA2. In the example of FIG. 1C, the normal area NA is not present between the first optical area OA1 and the second optical area OA2. In other words, the first optical area OA1 and the second optical area OA2 touch each other. At least a portion of the first optical area OA 1 may overlap the first electronic device 11, and at least a portion of the second optical area OA2 may overlap the second electronic device 12.

The one or more optical areas OA1 and OA2 should have both an image display structure and a light transmission structure. In other words, since the one or more optical areas OA1 and OA2 are partial areas of the display area DA, emission areas of subpixels for displaying images should be disposed in the one or more optical areas OA1 and OA2. A light transmission structure for transmitting light to the one or more electronic devices 11 and 12 should be formed in one or more optical areas OA1 and OA2.

The one or more electronic devices 11 and 12 are positioned behind (below, opposite to the viewing surface) the display panel 110 to receive the light transmitted through the display panel 110.

The one or more electronic devices 11 and 12 are not exposed on the front surface (viewing surface) of the display panel 110. Therefore, when the user looks at the front surface of the display panel 110, the electronic devices 11 and 12 are not visible to the user.

For example, the first electronic device 11 may be a camera that receives light (visible light) in a visible light wavelength band, and the second electronic device 12 may be a detection sensor, such as a proximity sensor or an illuminance sensor. For example, the detection sensor may be an infrared sensor that detects light (infrared light) in an infrared light wavelength range. Conversely, the first electronic device 11 may be a detection sensor, and the second electronic device 12 may be a camera.

Hereinafter, for convenience of description, it is assumed that the first electronic device 11 is a camera and the second electronic device 12 is an infrared (IR)-based detection sensor. The camera may be a camera lens or an image sensor.

If the first electronic device 11 is a camera, the camera may be a front camera that is positioned behind (below) the display panel 110 but captures forward of the display panel 110. Accordingly, the user may capture (self-capture) through the camera invisible to the viewing surface while viewing the viewing surface of the display panel 110.

The normal area NA and one or more optical areas OA1 and OA2 included in the display area DA may be areas capable of displaying an image. However, the normal area NA may be an area where a light transmission structure is not required to be formed, and one or more optical areas OA1 and OA2 may be areas in which a light transmission structure is to be formed.

Accordingly, the one or more optical areas OA1 and OA2 should have a transmittance higher than or equal to a certain level, and the normal area NA may have no light transmittance or a lower transmittance less than the certain level.

For example, one or more optical areas OA1 and OA2 and the normal area NA may have different resolutions, subpixel placement structures, numbers of subpixels per unit area, electrode structures, line structures, electrode placement structures, or line placement structures.

For example, the number of subpixels per unit area in one or more optical areas OA1 and OA2 may be smaller than the number of subpixels per unit area in the normal area NA. In other words, the resolution of one or more optical areas OA1 and OA2 may be lower than the resolution of the normal area NA. Here, the number of subpixels per unit area may be meant to be equivalent to resolution, or pixel density, or pixel integration degree. For example, the unit for the number of subpixels per unit area may be pixels per inch (PPI), which means the number of pixels in one inch.

For example, the number of subpixels per unit area in the first optical area OA1 may be smaller than the number of subpixels per unit area in the normal area NA. The number of subpixels per unit area in the second optical area OA2 may be larger than or equal to the number of subpixels per unit area in the first optical area OA1 and be smaller than the number of subpixels per unit area in the normal area NA.

Meanwhile, as one method for increasing the transmittance of at least one of the first optical area OA1 and the second optical area OA2, a pixel density differential design scheme may be applied as described above. According to the pixel density differential design scheme, the display panel 110 may be designed so that the number of subpixels per unit area of at least one of the first optical area OA1 and the second optical area OA2 is smaller than the number of subpixels per unit area of the normal area NA.

However, in some cases, as another method for increasing the transmittance of at least one of the first optical area OA1 and the second optical area OA2, a pixel size differential design scheme may be applied. According to the pixel size differential design scheme, the display panel 110 may be designed so that the number of subpixels per unit area of at least one of the first optical area OA1 and the second optical area OA2 is identical or similar to the number of subpixels per unit area of the normal area NA, and the size of each subpixel (i.e., the size of the emission area) disposed in at least one of the first optical area OA1 and the second optical area OA2 is smaller than the size of each subpixel SP (i.e., the size of the emission area) disposed in the normal area NA.

Hereinafter, for convenience of description, it is assumed in the following description that, of the two schemes (pixel density differential design scheme and pixel size differential design scheme) for increasing the transmittance of at least one of the first optical area OA1 and the second optical area OA2, the pixel density differential design scheme is applied. Accordingly, that the number of subpixels per unit area is small, as described below, may be an expression corresponding to the subpixel size being small, and that the number of subpixels per unit area is large may be an expression corresponding to the subpixel size being large.

The first optical area OA1 may have various shapes, such as a circle, an ellipse, a quadrangle, a hexagon, or an octagon. The second optical area OA2 may have various shapes, such as a circle, an ellipse, a square, a hexagon, or an octagon. The first optical area OA1 and the second optical area OA2 may have the same shape or different shapes.

Referring to FIG. 1C, when the first optical area OA1 and the second optical area OA2 touch, the entire optical area including the first optical area OA1 and the second optical area OA2 may have various shapes, such as a circle, an ellipse, a square, a hexagon, or an octagon. Hereinafter, for convenience of description, each of the first optical area OA1 and the second optical area OA2 is exemplified as having a circular shape.

In the display device 100 according to embodiments of the disclosure, if the first electronic device 11 that is not exposed to the outside and is hidden in a lower portion of the display panel 100 is a camera, the display device 100 according to embodiments of the disclosure may be referred to as a display to which under display camera (UDC) technology has been applied.

Accordingly, the display device 100 according to embodiments of the disclosure does not require a notch or camera hole for camera exposure to be formed in the display panel 110, thereby preventing a reduction in the display area DA. Thus, as there is no need to form a notch or camera hole for exposure of the camera in the display panel 110, the size of the bezel area may be reduced, and design restrictions may be freed, thereby increasing the degree of freedom in design.

In the display device 100 according to embodiments of the disclosure, although one or more electronic devices 11 and 12 are positioned to be hidden behind the display panel 110, one or more electronic devices 11 and 12 should be able to normally perform predetermined functions by normally receiving light.

Further, in the display device 100 according to embodiments of the disclosure, although one or more electronic devices 11 and 12 are positioned to be hidden behind the display panel 110 and are positioned to overlap the display area DA, the one or more optical areas OA1 and OA2 overlapping the one or more electronic devices 11 and 12 in the display area DA should be capable of normal image display.

Since the above-mentioned first optical area OA1 is designed as a transmittable area (or a transmissive area), the image display characteristics in the first optical area OA1 may differ from the image display characteristics in the normal area NA.

Further, in designing the first optical area OA1 to enhance the image display characteristics, the transmittance of the first optical area OA1 may be degraded.

Accordingly, embodiments of the disclosure propose a structure of the first optical area OA1 capable of enhancing transmittance in the first optical area OA1 without causing an image quality deviation between the first optical area OA1 and the normal area NA.

Further, embodiments of the disclosure propose a structure of the second optical area OA2 capable of enhancing transmittance in the second optical area OA2 and image quality in the second optical area OA2 for the second optical area OA2, as well as for the first optical area OA1.

Further, in the display device 100 according to embodiments of the disclosure, the first optical area OA1 and the second optical area OA2 are similar in that they are light transmittable areas (or light transmissive areas), but differ in use cases.

Therefore, in the display device 100 according to embodiments of the disclosure, the structure of the first optical area OA1 and the structure of the second optical area OA2 are basically similar or the same, but they may differ in, e.g., resolution, subpixel arrangement structure, number of subpixels in unit area, electrode structure, line structure, electrode arrangement structure, or line arrangement structure.

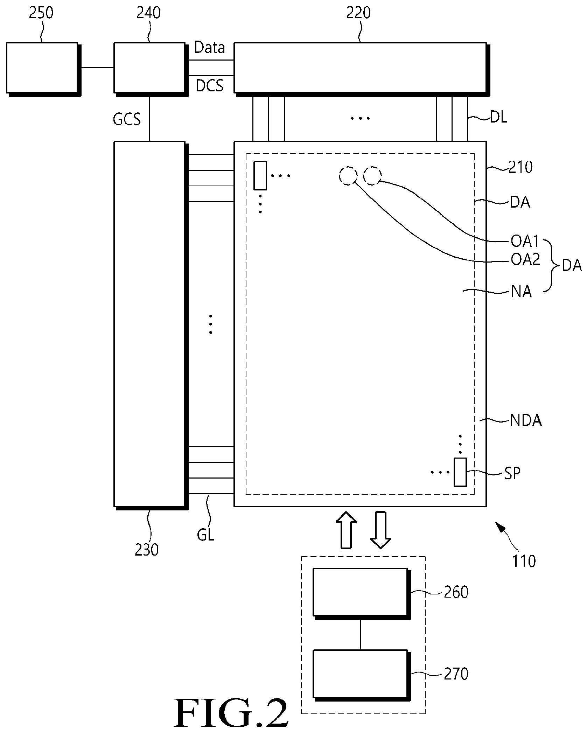

FIG. 2 is a view illustrating a system configuration of a display device 100 according to embodiments of the disclosure.

Referring to FIG. 2, a display device 100 may include a display panel 110 and display driving circuits, as components for displaying images. The display driving circuits are circuits for driving the display panel 110 and may include a data driving circuit 220, a gate driving circuit 230, and a display controller 240.

The display panel 110 may include a display area DA in which images are displayed and a non-display area NDA in which no image is displayed. The non-display area NDA may be an outer area of the display area DA and be referred to as a bezel area. The whole or part of the non-display area NDA may be an area visible from the front surface of the display device 100 or an area that is bent and not visible from the front surface of the display device 100.

The display panel 110 may include a substrate 210 and a plurality of subpixels SP disposed on the substrate 210. The display panel 110 may further include various types of signal lines to drive the plurality of subpixels SP.

The display device 100 according to embodiments of the disclosure may be a liquid crystal display device or a self-emission display device in which the display panel 110 emits light by itself. When the display device 100 according to the embodiments of the disclosure is a self-emission display device, each of the plurality of subpixels SP may include a light emitting element. For example, the display device 100 according to embodiments of the disclosure may be an organic light emitting diode display in which the light emitting element is implemented as an organic light emitting diode (OLED). As another example, the display device 100 according to embodiments of the disclosure may be an inorganic light emitting display device in which the light emitting element is implemented as an inorganic material-based light emitting diode. As another example, the display device 100 according to embodiments of the disclosure may be a quantum dot display device in which the light emitting element is implemented as a quantum dot which is self-emission semiconductor crystal.

The structure of each of the plurality of subpixels SP may vary according to the type of the display device 100. For example, when the display device 100 is a self-emission display device in which the subpixels SP emit light by themselves, each subpixel SP may include a light emitting element that emits light by itself, one or more transistors, and one or more capacitors.

For example, various types of signal lines may include a plurality of data lines DL transferring data signals (also referred to as data voltages or image signals) and a plurality of gate lines GL transferring gate signals (also referred to as scan signals).

The plurality of data lines DL and the plurality of gate lines GL may cross each other. Each of the plurality of data lines DL may be disposed to extend in a first direction. Each of the plurality of gate lines GL may be disposed to extend in a second direction. Here, the first direction may be a column direction and the second direction may be a row direction. The first direction may be the row direction and the second direction may be the column direction. For convenience of description, described below is an example in which each of the plurality of data lines DL is disposed in the column direction, and each of the plurality of gate lines GL is disposed in the row direction.

The data driving circuit 220 is a circuit for driving the plurality of data lines DL and may output data signals to the plurality of data lines DL. The gate driving circuit 230 is a circuit for driving the plurality of gate lines GL and may output gate signals to the plurality of gate lines GL.

The display controller 240 is a device for controlling the data driving circuit 220 and the gate driving circuit 230 and may control driving timings for the plurality of data lines DL and driving timings for the plurality of gate lines GL.

The display controller 240 may supply a data driving control signal DCS to the data driving circuit 220 to control the data driving circuit 220 and may supply a gate driving control signal GCS to the gate driving circuit 230 to control the gate driving circuit 230.

The display controller 240 may receive input image data from the host system 250 and supply image data Data to the data driving circuit 220 based on the input image data.

The data driving circuit 220 may receive digital image data Data from the display controller 240 and may convert the received image data Data into analog data signals and output the analog data signals to the plurality of data lines DL.

The gate driving circuit 230 may receive a first gate voltage corresponding to a turn-on level voltage and a second gate voltage corresponding to a turn-off level voltage, along with various gate driving control signals GCS, generate gate signals, and supply the generated gate signals to the plurality of gate lines GL.

Meanwhile, at least one of the data driving circuit 220 and the gate driving circuit 230 may be disposed in the display area DA of the display panel 110. For example, at least one of the data driving circuit 220 and the gate driving circuit 230 may be disposed not to overlap the subpixels SP or to overlap all or some of the subpixels SP.

The data driving circuit 220 may be connected to one side (e.g., an upper or lower side) of the display panel 110. Depending on the driving scheme or the panel design scheme, data driving circuits 220 may be connected with both the sides (e.g., both the upper and lower sides) of the display panel 110, or two or more of the four sides of the display panel 110.

The gate driving circuit 230 may be connected to one side (e.g., a left or right side) of the display panel 110. Depending on the driving scheme or the panel design scheme, gate driving circuits 230 may be connected with both the sides (e.g., both the left and right sides) of the display panel 110, or two or more of the four sides of the display panel 110.

The display controller 240 may be implemented as a separate component from the data driving circuit 220, or the display controller 240 and the data driving circuit 220 may be integrated into an integrated circuit (IC).

The display controller 240 may be a timing controller used in typical display technology, a control device that may perform other control functions as well as the functions of the timing controller, or a control device other than the timing controller, or may be a circuit in the control device.

The display controller 240 may be mounted on a printed circuit board or a flexible printed circuit and may be electrically connected with the data driving circuit 220 and the gate driving circuit 230 through the printed circuit board or the flexible printed circuit.

To provide a touch sensing function as well as an image display function, the display device 100 according to embodiments of the disclosure may include a touch sensor and a touch sensing circuit that senses the touch sensor to detect whether a touch occurs by a touch object, such as a finger or pen, or the position of the touch.

The touch sensing circuit may include a touch driving circuit 260 that drives and senses the touch sensor and generates and outputs touch sensing data and a touch controller 270 that may detect an occurrence of a touch or the position of the touch using touch sensing data.

The touch sensor may include a plurality of touch electrodes. The touch sensor may further include a plurality of touch lines for electrically connecting the plurality of touch electrodes and the touch driving circuit 260.

The touch sensor may be present in a touch panel form outside the display panel 110 or may be present inside the display panel 110. When the touch sensor, in the form of a touch panel, exists outside the display panel 110, the touch sensor is referred to as an external type. When the touch sensor is of the external type, the touch panel and the display panel 110 may be separately manufactured or may be combined during an assembly process. The external-type touch panel may include a touch panel substrate and a plurality of touch electrodes on the touch panel substrate.

When the touch sensor is present inside the display panel 110, the touch sensor may be formed on the substrate 210, together with signal lines and electrodes related to display driving, during the manufacturing process of the display panel 110.

The touch driving circuit 260 may supply a touch driving signal to at least one of the plurality of touch electrodes and may sense at least one of the plurality of touch electrodes to generate touch sensing data.

The touch sensing circuit may perform touch sensing in a self-capacitance sensing scheme or a mutual-capacitance sensing scheme.

The touch driving circuit 260 and the touch controller 270 included in the touch sensing circuit may be implemented as separate devices or as a single device. The touch driving circuit 260 and the data driving circuit 220 may be implemented as separate devices or as a single device.

The display device 100 may further include a power supply circuit for supplying various types of power to the display driver integrated circuit and/or the touch sensing circuit.

As described above, the display area DA in the display panel 110 may include the normal area NA and one or more optical areas OA1 and OA2. The normal area NA and one or more optical areas OA1 and OA2 are areas capable of displaying an image. However, the normal area NA is an area where a light transmission structure is not required to be formed, and one or more optical areas OA1 and OA2 are areas in which a light transmission structure is to be formed.

As described above, the display area DA in the display panel 110 may include one or more optical areas OA1 and OA2 together with the normal area NA, but for convenience of description, it is assumed that the display area DA includes both the first optical area OA1 and the second optical area OA2 (FIGS. 1B and 1C).

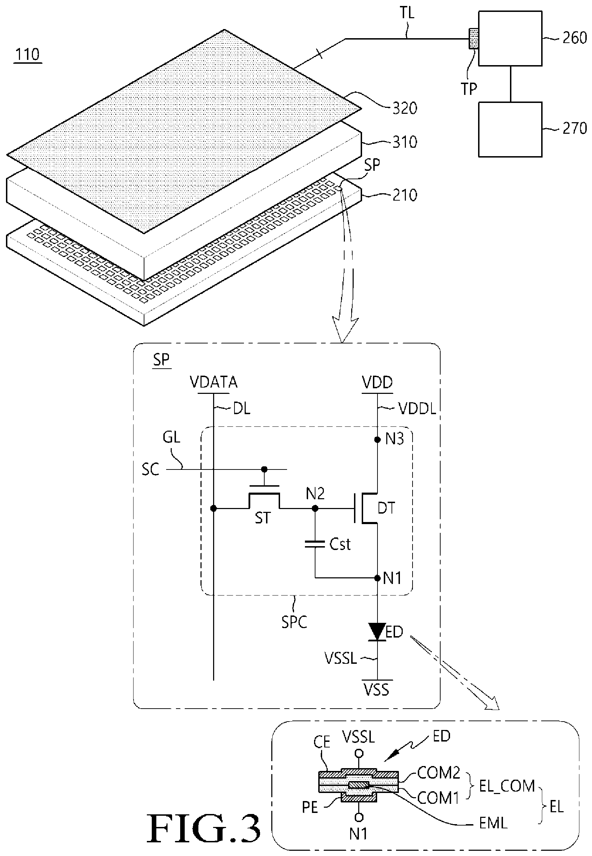

FIG. 3 illustrates a display panel 110 according to an embodiment of the disclosure.

Referring to FIG. 3, a plurality of subpixels SP may be disposed in the display area DA of the display panel 110. The plurality of subpixels SP may be disposed in the normal area NA and the first optical area OA1 and the second optical area OA2 included in the display area DA.

Referring to FIG. 3, each of the plurality of subpixels SP may include a light emitting element ED and a subpixel circuit SPC configured to drive the light emitting element ED.

Referring to FIG. 3, the subpixel circuit SPC may include a driving transistor DT for driving the light emitting element ED, a scan transistor ST for transferring the data voltage Vdata to the driving transistor DT, and a storage capacitor Cst for maintaining a constant voltage during one frame.

The driving transistor DT may include a first node N1, a second node N2, and a third node N3.

The first node N1 may be electrically connected to the light emitting element ED. The second node N2 may be electrically connected to the scan transistor ST. The third node N3 may be electrically connected to the driving voltage line VDDL.

The first node N1 may be electrically connected to the pixel electrode PE of the light emitting element ED. A data voltage VDATA may be applied to the second node N2. A driving voltage VDD may be applied to the third node N3.

The first node N1 may be the source node or the drain node, the second node N2 may be the gate node, and the third node N3 may be the drain node or the source node. For convenience of description, described below is an example in which the first node N1 in the driving transistor DT is the source node, the second node N2 is the gate node, and the third node N3 is the drain node.

The light emitting element ED may include a pixel electrode PE, an intermediate layer EL, and a common electrode CE.

The pixel electrode PE may be an electrode disposed in each subpixel SP. For example, the pixel electrode PE may be electrically connected directly or indirectly (through another transistor) to the first node N1 of the driving transistor DT of each subpixel SP.

The common electrode CE may be an electrode commonly disposed in a plurality of subpixels SP. For example, the common electrode CE may be electrically connected to the base voltage line VSSL. The base voltage VSS, which is one type of the common driving voltage, may be applied to the common electrode CE through the base voltage line VSSL.

For example, the pixel electrode PE may be an anode electrode, and the common electrode CE may be a cathode electrode. Conversely, the pixel electrode PE may be a cathode electrode, and the common electrode CE may be an anode electrode. For convenience of description, it is assumed below that the pixel electrode PE is an anode electrode, and the common electrode CE is a cathode electrode.

The intermediate layer EL may include a light emitting layer EML and a common intermediate layer EL_COM.

As an example, the light emitting layer EML may be disposed in each of the plurality of subpixels SP, or as another example, may be commonly disposed in the plurality of subpixels SP. The common intermediate layer EL_COM may be commonly disposed over the plurality of subpixels SP.

The light emitting layer EML may be disposed for each emission area, and the common intermediate layer EL_COM may be commonly disposed over the plurality of emission area EA and the non-emission area.

The common intermediate layer EL_COM may include a first common intermediate layer COM1 and a second common intermediate layer COM2. The first common intermediate layer COM1 may be disposed between the pixel electrode PE and the light emitting layer EML and may include at least one layer (e.g., an organic layer). The second common intermediate layer COM2 may be disposed between the light emitting layer EML and the common electrode CE and may include at least one layer (e.g., an organic layer).

For example, the first common intermediate layer COM1 may include a hole injection layer and a hole transport layer. The second common intermediate layer COM2 may include an electron transport layer and an electron injection layer.

The hole injection layer may inject holes from the pixel electrode PE to the hole transport layer, the hole transport layer may transport the holes to the light emitting layer EML, the electron injection layer may inject electrons from the common electrode CE to the electron transport layer, and the electron transport layer may transport electrons to the light emitting layer EML.

Each light emitting element ED may include portions where the pixel electrode PE, the light emitting layer EML in the intermediate layer EL, and the common electrode CE overlap. A predetermined emission area EA may be formed by the light emitting element ED. For example, the emission area EA may be defined as an area where the pixel electrode PE, the light emitting layer EML of the intermediate layer EL, and the common electrode CE overlap.

For example, the light emitting element ED may be an organic material-based organic light emitting diode (OLED), an inorganic material-based inorganic light emitting diode, or a quantum dot light emitting element. When the light emitting element ED is an organic light emitting diode, the intermediate layer EL of the light emitting element ED may include an organic layer including an organic material.

The scan transistor ST may be controlled to be turned on and off by the scan signal SC, which is a kind of gate signal applied through the scan signal line GL, which is a type of the gate line GL, and be electrically connected between the second node N2 of the driving transistor DT and the data line DL.

The storage capacitor Cst may be electrically connected between the first node N1 and second node N2 of the driving transistor DT.

As illustrated in FIG. 3, the subpixel circuit SPC may have a 2T (Transistor)1C (Capacitor) structure including two transistors DT and ST and one capacitor Cst. In some cases, the subpixel circuit SPC may further include one or more transistors or may further include one or more capacitors.

The capacitor Cst may be an external capacitor intentionally designed to be outside the driving transistor DT, but not a parasitic capacitor which is an internal capacitor that may be present between the first node N1 and the second node N2 of the driving transistor DT. Each of the driving transistor DT and the scan transistor ST may be an n-type transistor or a p-type transistor.

Since the circuit elements (especially the light emitting element ED implemented as an organic light emitting diode (OLED) including an organic material) in each subpixel SP are vulnerable to external moisture or oxygen, the encapsulation layer 310 for preventing external moisture or oxygen from penetrating into the circuit elements (especially the light emitting element ED) may be disposed on the display panel 110. The encapsulation layer 310 may be disposed to cover the light emitting elements ED.

Referring to FIG. 3, a display device 100 according to embodiments of the disclosure may include a touch sensor layer 320 including a plurality of sensor electrodes to sense the user's touch, a touch driving circuit 260 configured to sense the plurality of sensor electrodes, and a touch controller 270 configured to determine the presence or absence of a touch or touch coordinates using the sensing result (touch sensing data) of the touch driving circuit 260.

The touch sensor layer 320 may be embedded in the display panel 110. For example, the touch sensor layer 320 may be disposed on the encapsulation layer 310 in the display panel 110.

The display panel 110 may further include a plurality of touch pads TP electrically connected to the touch driving circuit 260 and a plurality of touch routing lines for electrically connecting the plurality of sensor electrodes included in the touch sensor layer 320 to the plurality of touch pads TP connected to the touch driving circuit 260.

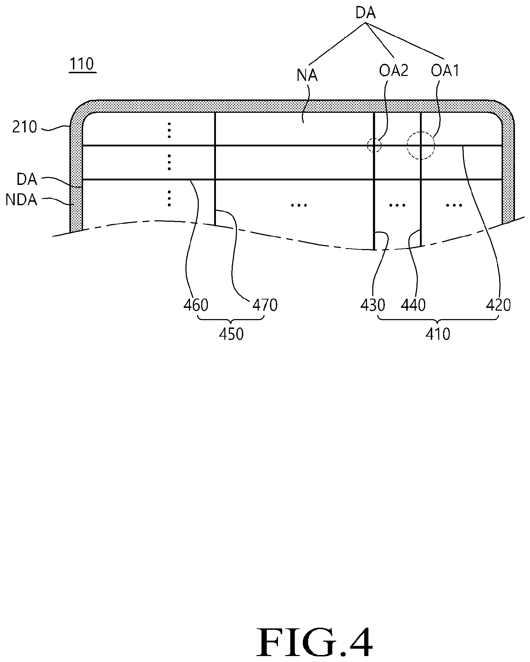

FIG. 4 illustrates signal lines SL disposed on a display panel 110 according to embodiments of the disclosure.

Referring to FIG. 4, the display panel 110 according to embodiments of the disclosure may include a plurality of subpixels SP and a plurality of signal lines 410 and 450 for driving the plurality of subpixels SP.

Referring to FIG. 4, each of the plurality of subpixels SP may include a light emitting element ED and a subpixel circuit SPC for driving the light emitting element ED. The emission area EA may be formed by the light emitting element ED.

Referring to FIG. 4, the plurality of signal lines 410 and 450 may supply various driving signals required to drive the plurality of subpixels SP to the plurality of subpixels SP.

For example, various driving signals may include a data signal Vdata for driving the data line DL, a scan signal SC for driving the gate line GL, and the like. The various driving signals may further include a driving voltage for driving a driving voltage line and a base voltage for driving a common base voltage line.

Accordingly, the plurality of signal lines may include a plurality of data lines DL for supplying data signals Vdata and a plurality of gate lines GL for supplying gate signals such as scan signals SC. The plurality of signal lines may further include a driving voltage line and a base voltage line.

Referring to FIG. 4, the display area DA may include a normal area NA, a first optical area OA1, and a second optical area OA2.

Referring to FIG. 4, each of the normal area NA, the first optical area OA1, and the second optical area OA2 may include a plurality of emission areas EA. A plurality of light emitting elements ED and a plurality of subpixel circuits SPC may be disposed in each of the normal area NA, the first optical area OA1, and the second optical area OA2.

Referring to FIG. 4, the plurality of signal lines 410 and 450 may include a plurality of normal signal lines 450 and a plurality of specific signal lines 410.

The plurality of normal signal lines 450 may be signal lines disposed only in the normal area NA without passing through the first optical area OA1 and the second optical area OA2.

The plurality of specific signal lines 410 may be signal lines passing through at least one of the first optical area OA1 and the second optical area OA2.

For example, the plurality of normal signal lines 450 may include a plurality of data lines 470 and a plurality of gate lines 460 that do not pass through the first optical area OA1 and the second optical area OA2.

For example, the plurality of specific signal lines 410 may include a plurality of data lines 430 and 440 and a plurality of gate lines 420 passing through at least one of the first optical area OA1 and the second optical area OA2.

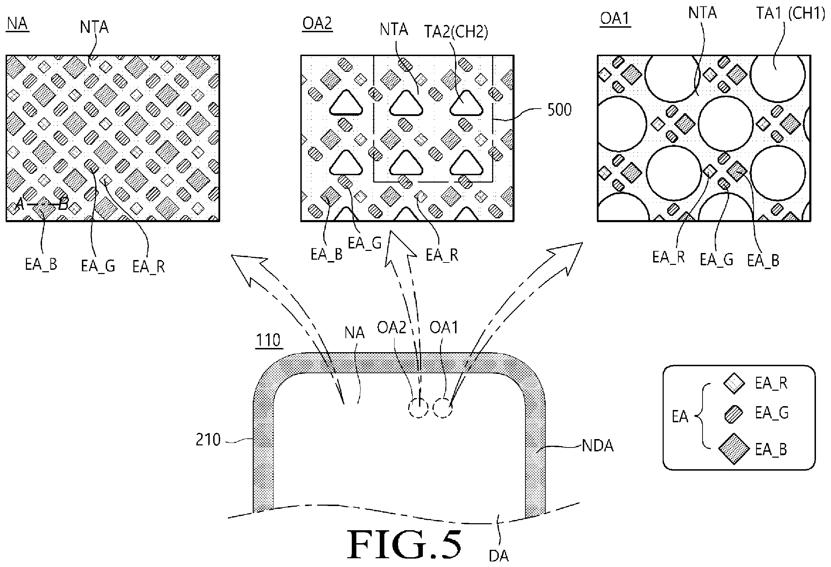

FIG. 5 illustrates a normal area NA, a first optical area OA1, and a second optical area OA2 in a display panel according to embodiments of the disclosure.

Referring to FIG. 5, the display panel 110 according to embodiments of the disclosure may include a display area DA in which images are displayed and a non-display area NDA in which no image is displayed. The display area DA may include a first optical area OA1, a second optical area OA2, and a normal area NA.

Since the first optical area OA1, the second optical area OA2, and the normal area NA are included in the display area DA, they may have a display structure. For example, each of the first optical area OA1, the second optical area OA2, and the normal area NA may include a plurality of emission areas.

Further, the first optical area OA1 and the second optical area OA2 may be areas capable of light transmission, and the normal area NA may be an area in which light transmission is impossible or light transmission is insignificant. The normal area NA may mean an area where light may (substantially) not be transmitted, other than the first optical area OA1 and the second optical area OA2. Here, the transmission of light may mean that light passes between the front surface and the rear surface of the display panel 110. In other words, in the display area DA, the normal area NA may be a display area other than or different from the optical areas OA1 and OA2.

The first optical area OA1 may be an area overlapping the first electronic device 11. The second optical area OA2 may be an area overlapping the second electronic device 12.

Each of the first optical area OA1 and the second optical area OA2 may have a light transmission structure. However, the first optical area OA1 and the second optical area OA2 may have different structural characteristics. For example, the transmittance of the first optical area OA1 may be higher than the transmittance of the second optical area OA2. The resolution or the number of subpixels per unit area of the first optical area OA1 may be lower than the resolution or the number of subpixels per unit area of the second optical area OA2.

The first electronic device 11 may perform a predetermined operation using a first wavelength band of light transmitted through the first optical area OA1. The second electronic device 12 may perform a predetermined operation using a second wavelength band different from the first wavelength band of light transmitted through the second optical area OA2.

The first wavelength band may include one or more of a wavelength band of visible light, a wavelength band of infrared light, and a wavelength band of ultraviolet light. The second wavelength band may include one or more of a wavelength band of visible light, a wavelength band of infrared light, and a wavelength band of ultraviolet light, but may be different from the first wavelength band.

For example, the first electronic device 11 may be a camera and the second electronic device 12 may be a detection sensor. The first electronic device 11 may perform a camera operation using light of a visible wavelength band corresponding to a first wavelength band of light transmitted through the first optical area OA1. The second electronic device 12 may perform a detection operation using light of an infrared wavelength band corresponding to the second wavelength band of light transmitted through the second optical area OA2.

Referring to FIG. 5, each of the first optical area OA1 and the second optical area OA2 may be circular or octagonal. However, the disclosure is not limited thereto, and each of the first optical area OA1 and the second optical area OA2 may have various shapes such as an elliptical shape, a polygonal shape, or an irregular shape.

The first optical area OA1 and the second optical area OA2 may have the same shape. Alternatively, the first optical area OA1 and the second optical area OA2 may have different shapes.

Referring to FIG. 5, the display area DA may include a plurality of emission areas EA. Since the normal area NA, the first optical area OA1, and the second optical area OA2 are areas included in the display area DA, each of the normal area NA, the first optical area OA1, and the second optical area OA2 may include a plurality of emission areas EA.

The plurality of emission areas EA may include emission areas emitting light of three or more colors. For example, the plurality of emission areas EA may include a first color emission area emitting first color light, a second color emission area emitting second color light, and a third color emission area emitting third color light.

For example, when the first color light is red light, the second color light is green light, and the third color light is blue light, the first color emission area may be referred to as a red emission area EA_R, the second color emission area may be referred to as a green emission area EA_G, and the third color emission area may be referred to as a blue emission area EA_B.

The red emission area EA_R, the green emission area EA_G, and the blue emission area EA_B may have the same size (emission area size). Alternatively, at least one of the red emission area EA_R, the green emission area EA_G, and the blue emission area EA_B may have a size (emission area size) different from the rest.

As mentioned above, the first color, the second color, and the third color are different colors and may be various colors. For example, the first color, the second color, and the third color may include red, green, and blue. Hereinafter, for convenience of description, a case in which the first color is red, the second color is green, and the third color is blue is exemplified. However, embodiments of the disclosure are not limited thereto.

When the first color is red, the second color is green, and the third color is blue, the size (emission area size) of the blue emission area EA_B may be the largest among the size (emission area size) of the red emission area EA_R, the size (emission area size) of the green emission area EA_G, and the size (emission area size) of the blue emission area EA_B.

The light emitting element ED disposed in the red emission area EA_R may include a light emitting layer EML emitting red light. The light emitting element ED disposed in the green emission area EA_G may include a light emitting layer EML emitting green light. The light emitting element ED disposed in the blue emission area EA_B may include a light emitting layer EML emitting blue light.

Among the light emitting layer EML emitting red light, the light emitting layer EML emitting green light, and the light emitting layer EML emitting blue light, an organic material included in the light emitting layer EML emitting blue light may be most easily deteriorated. Thus, as the size of the blue emission area EA_B is designed to be the largest, the density of the current supplied to the light emitting element ED disposed in the blue emission area EA_B may be the smallest. Accordingly, the degree of deterioration of the light emitting element ED disposed in the blue emission area EA_B may be similar to the degree of deterioration of the light emitting element ED disposed in the red emission area EA_R and the degree of deterioration of the light emitting element ED disposed in the green emission area EA_G.

Accordingly, the deterioration deviations between the light emitting element ED disposed in the red emission area EA_R, the light emitting element ED disposed in the green emission area EA_G, and the light emitting element ED disposed in the blue emission area EA_B may be removed or reduced, thereby improving image quality.

Referring to FIG. 5, each of the plurality of first transmissive areas TA1 included in the first optical area OA1 may have various shapes such as an elliptical shape, a polygonal shape, or an irregular shape. Each of the plurality of second transmissive areas TA2 included in the second optical area OA2 may have various shapes such as an elliptical shape, a polygonal shape, or an irregular shape.

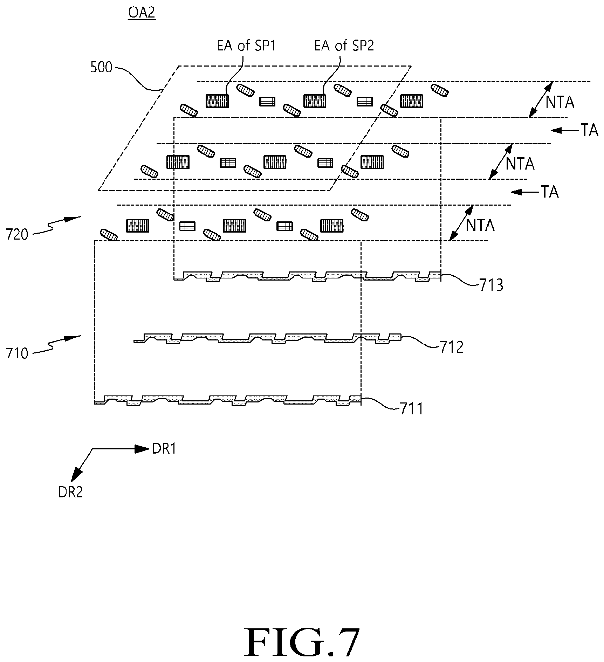

The transmissive areas TA1 and TA2 may have relatively higher transmittances than the non-transmissive area NTA. To that end, the common electrode CE corresponding to the transmissive areas TA1 and TA2 may be etched and removed. Further, metals for the transistors illustrated in FIG. 3 may not be disposed in the transmissive areas TA1 and TA2. Therefore, the transmissive areas TA1 and TA2 may be areas where the common electrode CE is etched and removed, and may be the transmissive areas TA1 and TA2 illustrated in FIG. 5, for example. Further, the transmissive areas TA1 and TA2 may be areas where metals for transistors are not disposed, and may be the transmissive area TA illustrated in FIG. 7, for example.

The plurality of first transmissive areas TA1 may have the same shape. Alternatively, some of the plurality of first transmissive areas TA1 may have a different shape from the rest. The plurality of second transmissive areas TA2 may have the same shape. Alternatively, some of the plurality of second transmissive areas TA2 may have a different shape from the rest.

The first transmissive area TA1 and the second transmissive area TA2 may have the same shape. Alternatively, the first transmissive area TA1 and the second transmissive area TA2 may have different shapes.

Referring to FIG. 5, the entire normal area NA may correspond to a non-transmissive area. In other words, the normal area NA may include a non-transmissive area NTA including a plurality of emission areas EA. In other words, the entire normal area NA may be the non-transmissive area NTA, and the normal area NA may not include the transmissive area TA.

The first optical area OA1 may further include a non-transmissive area NTA including a plurality of emission areas EA and a plurality of first transmissive areas TA1. The non-transmissive area NTA included in the first optical area OA1 may be an area through which light is not transmitted at all or may be an area through which light is transmitted with a transmittance lower than that of the first transmissive area TA1.

The second optical area OA2 may further include a non-transmissive area NTA including a plurality of emission areas EA and a plurality of second transmissive areas TA2. The non-transmissive area NTA included in the second optical area OA2 may be an area through which light is not transmitted at all or may be an area through which light is transmitted with a transmittance lower than that of the second transmissive area TA2.

Meanwhile, the common electrode CE may include a plurality of common electrode holes CH1 and CH2 corresponding to a plurality of openings. The plurality of common electrode holes CH1 and CH2 may be formed in the first optical area OA1 and the second optical area OA2. In other words, the positions where the plurality of common electrode holes CH1 and CH2 are formed may be the first optical area OA1 and the second optical area OA2.

Referring to FIG. 5, the positions where the plurality of common electrode holes CH1 are formed in the common electrode CE may correspond to the plurality of first transmissive areas TA1 included in the first optical area OA1, respectively. Further, the positions where the plurality of common electrode holes CH2 are formed in the common electrode CE may correspond to the plurality of second transmissive areas TA2 included in the second optical area OA2, respectively. Accordingly, the transmittance of each of the first optical area OA1 and the second optical area OA2 may be enhanced.

Referring to FIG. 5, the A-B cross-section area is depicted in the normal area NA. A cross-sectional view of the A-B area is described below.

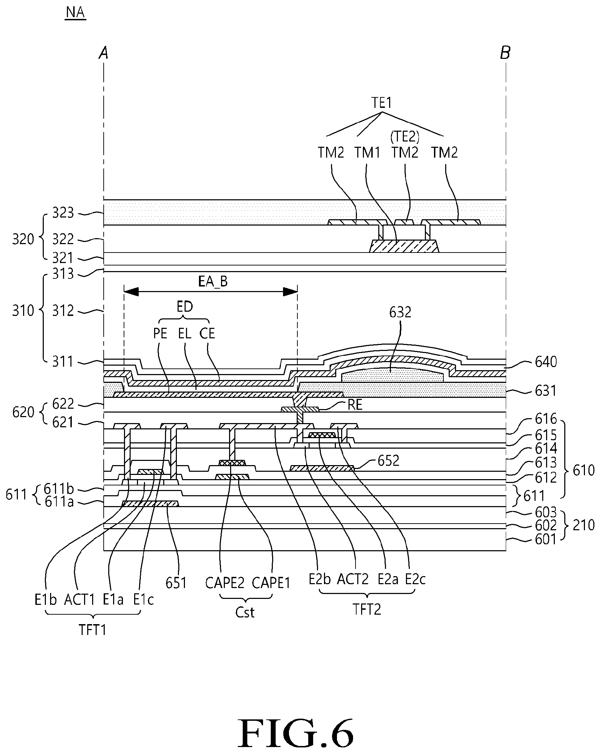

FIG. 6 is a cross-sectional view of area A-B of the normal area NA of FIG. 5 according to one embodiment.

Referring to FIG. 6, the display panel 110 according to embodiments of the disclosure may include a transistor unit, a light emitting element unit, and an encapsulation unit, but embodiments of the disclosure are not limited thereto.

The substrate 210 may be a single layer or multiple layers. When the substrate 210 includes multiple layers, the substrate 210 may include a first substrate 601, an intermediate layer 602, and a second substrate 603. The intermediate layer 602 may be positioned between the first substrate 601 and the second substrate 603. For example, each of the first substrate 601 and the second substrate 603 may be a polyimide (PI) layer, but embodiments of the disclosure are not limited thereto. The intermediate layer 602 may be an inorganic insulation layer, but embodiments of the disclosure are not limited thereto. When an electric charge is charged to the first substrate 601 which is a polyimide layer, the intermediate layer 602 may prevent or at least reduce the electric charge from affecting transistors disposed on the second substrate 603 through the second substrate 603 which is a polyimide layer.

Further, the intermediate layer 602 may prevent a moisture component from penetrating upward through the first substrate 601. For example, the intermediate layer 602 may be formed of a single layer of silicon nitride (SiNx) or silicon oxide (SiOx) or multiple layers thereof or may be formed of a double layer of silicon dioxide (SiO2) and silicon nitride (SiNx), but is not limited thereto.

The transistor unit may include a substrate 210, an insulation layer 610, 611, 612, 613, 614, 615, and 616 on the substrate 210, thin film transistors TFT1 and TFT2, a storage capacitor Cst, and various electrodes or signal lines.

The thin film transistors TFT1 and TFT2 included in the transistor unit may include a first thin film transistor TFT1 and a second thin film transistor TFT2.

The first thin film transistor TFT1 may include a first active layer ACT1, a first electrode E1a, a second electrode E1b, and a third electrode E1c. The first active layer ACT1 may be a first semiconductor layer, but embodiments of the disclosure are not limited thereto. For example, the first active layer ACT1 may be formed of an oxide semiconductor, amorphous silicon, polysilicon, or low temperature polysilicon (LTPS), but embodiments of the disclosure are not limited thereto. The first thin film transistor TFT1 may be implemented as a p-channel transistor or an n-channel thin film transistor, but embodiments of the disclosure are not limited thereto.

The first electrode E1a may be a gate electrode, the second electrode E1b may be a source electrode or a drain electrode, and the third electrode E1c may be a drain electrode or a source electrode. Hereinafter, for convenience of description, the first electrode E1a is referred to as a first gate electrode E1a, the second electrode E1b is referred to as a first source electrode E1b, and the third electrode E1c is referred to as a first drain electrode E1c. However, embodiments of the disclosure are not limited thereto.

The second thin film transistor TFT2 may include a second active layer ACT2, a fourth electrode E2a, a fifth electrode E2b, and a sixth electrode E2c. The second active layer ACT2 may be a second semiconductor layer, but embodiments of the disclosure are not limited thereto. For example, the second active layer ACT2 may be formed of an oxide semiconductor, amorphous silicon, polysilicon, or low temperature polysilicon (LTPS), but embodiments of the disclosure are not limited thereto. The second thin film transistor TFT2 may be implemented as a p-channel transistor or an n-channel thin film transistor, but embodiments of the disclosure are not limited thereto.

For example, one of the first thin film transistor TFT1 and the second thin film transistor TFT2 may constitute an oxide semiconductor as an active layer. As another example, one of the first thin film transistor TFT1 and the second thin film transistor TFT2 may use low-temperature polysilicon as an active layer. As another example, the first thin film transistor TFT1 and the second thin film transistor TFT2 may configure an oxide semiconductor as an active layer. As another example, the first thin film transistor TFT1 and the second thin film transistor TFT2 may configure low-temperature polysilicon as an active layer. As another example, of the first thin film transistor TFT1 and the second thin film transistor TFT2, the driving transistor DT may configure an oxide semiconductor as an active layer, and the scan transistor ST may configure low-temperature polysilicon as an active layer. As another example, of the first thin film transistor TFT1 and the second thin film transistor TFT2, the driving transistor DT may configure low-temperature polysilicon as an active layer, and the scan transistor ST may configure an oxide semiconductor as an active layer. As another example, a transistor included in a gate driving circuit 230 of a gate in panel (GIP) type may configure an oxide semiconductor or low-temperature polysilicon as an active layer. As another example, all the transistors configured on the substrate 210 and transistors included in a gate driving circuit 230 of a gate in panel (GIP) type may configure an oxide semiconductor as an active layer.

The fourth electrode E2a may be a gate electrode, the fifth electrode E2b may be a source electrode or a drain electrode, and the sixth electrode E2c may be a drain electrode or a source electrode. Hereinafter, for convenience of description, the fourth electrode E2a is referred to as a second gate electrode E2a, the fifth electrode E2b is referred to as a second source electrode E2b, and the sixth electrode E2c is referred to as a second drain electrode E2c. However, embodiments of the disclosure are not limited thereto.

The second active layer ACT2 of the second thin film transistor TFT2 may be positioned higher from the substrate 210 than the first active layer ACT1 of the first thin film transistor TFT1.

The first buffer layer 611 may be disposed under the first active layer ACT1 of the first thin film transistor TFT1, and a second buffer layer 614 may be disposed under the second active layer ACT2 of the second thin film transistor TFT2. For example, the first active layer ACT1 of the first thin film transistor TFT1 may be positioned on the first buffer layer 611, and the second active layer ACT2 of the second thin film transistor TFT2 may be positioned on the second buffer layer 614. The second buffer layer 614 may be positioned higher than the first buffer layer 611.

The storage capacitor Cst may be disposed in various metal layers in the display panel 110. For example, the storage capacitor Cst may include a first capacitor electrode CAPE1 and a second capacitor electrode CAPE2.

The light emitting element unit may include a plurality of light emitting elements ED disposed on at least one planarization layer 621 and 622 (which may be collectively referred to as a planarization layer 620). Each of the plurality of light emitting elements ED may include a pixel electrode PE, an intermediate layer EL, and a common electrode CE.

A capping layer 640 may be disposed on the common electrode CE. The capping layer 640 may further increase the luminous efficiency of the display panel 110 by the micro cavity effect.

The encapsulation unit may include an encapsulation layer 310 on the plurality of light emitting elements ED. The encapsulation layer 310 may be a single layer or multiple layers, but embodiments of the disclosure are not limited thereto.

Hereinafter, a structure or a vertical structure of the display panel 110 according to embodiments of the disclosure is described in more detail with reference to FIG. 6.

Referring to FIG. 6, the first buffer layer 611 may be disposed on the substrate 210. The first buffer layer 611 may be a single layer or multiple layers, but embodiments of the disclosure are not limited thereto. When the first buffer layer 611 includes multiple layers, the first buffer layer 611 may include an upper buffer layer 611b and a lower buffer layer 611a.

The first active layer ACT1 of the first thin film transistor TFT1 may be disposed on the first buffer layer 611. The first active layer ACT1 may include a channel area in which a channel is formed, a source connection area on one side of the channel area, and a drain connection area on the other side of the channel area.

The first insulation layer 612 may be disposed on the first active layer ACT1 of the first thin film transistor TFT1. The first gate electrode E1a of the first thin film transistor TFT1 may be disposed on the first insulation layer 612. The second insulation layer 613 may be disposed on the first gate electrode E1a of the first thin film transistor TFT1. The first insulation layer 612 may be a gate insulation layer, but embodiments of the disclosure are not limited thereto. The second insulation layer 613 may be an interlayer insulation layer, but embodiments of the disclosure are not limited thereto.

The second buffer layer 614 may be disposed on the second insulation layer 613.

The second active layer ACT2 of the second thin film transistor TFT2 may be disposed on the second buffer layer 614. The second active layer ACT2 may include a channel area in which a channel is formed, a source connection area on one side of the channel area, and a drain connection area on the other side of the channel area.

The third insulation layer 615 may be disposed on the second active layer ACT2 of the second thin film transistor TFT2. The second gate electrode E2a of the second thin film transistor TFT2 may be disposed. The fourth insulation layer 616 may be disposed on the second gate electrode E2a of the second thin film transistor TFT2. The third insulation layer 615 may be a gate insulation layer, but embodiments of the disclosure are not limited thereto. The fourth insulation layer 616 may be an inter-layer insulation layer, but embodiments of the disclosure are not limited thereto.

The first source electrode E1b and the first drain electrode E1c of the first thin film transistor TFT1, and the second source electrode E2b and the second drain electrode E2c of the second thin film transistor TFT2 may be disposed on the fourth insulation layer 616.

The first source electrode E1b and the first drain electrode E1c of the first thin film transistor TFT1 may be connected to the source connection area and the drain connection area, respectively, of the first active layer ACT1 through holes of the fourth insulation layer 616, the third insulation layer 615, the second buffer layer 614, the second insulation layer 613, and the first insulation layer 612.

The second source electrode E2b and the second drain electrode E2c of the second thin film transistor TFT2 may be connected to the source connection area and the drain connection area, respectively, of the second active layer ACT2 through the holes of the fourth insulation layer 616 and the third insulation layer 615.

The first source electrode E1b and the first drain electrode E1c of the first thin film transistor TFT1, and the second source electrode E2b and the second drain electrode E2c of the second thin film transistor TFT2 may include a first metal and may be disposed in the first metal layer. Here, the first metal and the first metal layer may be referred to as a first source-drain metal and a first source-drain metal layer.

Referring to FIG. 6, the storage capacitor Cst may be formed by a first capacitor electrode CAPE1 and a second capacitor electrode CAPE2, for example. In some cases, the storage capacitor Cst may be formed by three or more capacitor electrodes or may have a form in which two or more capacitors are connected in parallel.

Each of the first capacitor electrode CAPE1 and the second capacitor electrode CAPE2 may be disposed on various metal layers disposed in the display panel 110.

For example, the first capacitor electrode CAPE1 may include the same first gate metal as the first gate electrode E1a of the first thin film transistor TFT1 on the first insulation layer 612 and may be disposed in the first gate metal layer, but embodiments of the disclosure are not limited thereto.

For example, the second capacitor electrode CAPE2 may be disposed on the second insulation layer 613.

The second source electrode E2b of the second thin film transistor TFT2 may be electrically connected to the second capacitor electrode CAPE2 through holes of the fourth insulation layer 616, the third insulation layer 615, and the second buffer layer 614.

For example, the first thin film transistor TFT1 may be the scan transistor ST of FIG. 3, and the second thin film transistor TFT2 may be the driving transistor DT of FIG. 3.

Referring to FIG. 6, the transistor unit may further include a first shield metal 651 disposed on the substrate 210. The first shield metal 651 may overlap the first active layer ACT1 of the first thin film transistor TFT1. The first shield metal 651 may be disposed under the first active layer ACT1 of the first thin film transistor TFT1. For example, the first shield metal 651 may be disposed between the substrate 210 and the first buffer layer 611 or may be disposed between the upper buffer layer 611b and the lower buffer layer 611a.

The transistor unit may further include a second shield metal 652 disposed on the substrate 210. The second shield metal 652 may overlap the second active layer ACT2 of the second thin film transistor TFT2. The second shield metal 652 may be disposed under the second active layer ACT2 of the second thin film transistor TFT2.

For example, the second shield metal 652 may be disposed in a metal layer between the second insulation layer 613 and the second buffer layer 614. The second shield metal 652 may be disposed in the same metal layer as the second capacitor electrode CAPE2, but embodiments of the disclosure are not limited thereto.

As another example, the second shield metal 652 may be disposed in the same first gate metal layer as the first gate electrode E1a of the first thin film transistor TFT1.

At least one planarization layer may be disposed on the first thin film transistor TFT1 and the second thin film transistor TFT2. In the example of FIG. 6, two planarization layers 621, 622 are disposed on the first thin film transistor TFT1 and the second thin film transistor TFT2. In some cases, three planarization layers may be disposed on the first thin film transistor TFT1 and the second thin film transistor TFT2, but embodiments of the disclosure are not limited thereto.

Referring to FIG. 6, the first planarization layer 621 may be disposed on the first source electrode E1b and the first drain electrode E1c of the first thin film transistor TFT1, and the second source electrode E2b and the second drain electrode E2c of the second thin film transistor TFT2. For example, the first planarization layer 621 may be disposed on the first thin film transistor TFT1 and the second thin film transistor TFT2. For example, the first planarization layer 621 may be disposed to cover both the first thin film transistor TFT1 and the second thin film transistor TFT2.

Referring to FIG. 6, a relay electrode RE may be disposed on the first planarization layer 621. The relay electrode RE may electrically connect the second source electrode E2b of the second thin film transistor TFT2 and the pixel electrode PE.

The relay electrode RE may be electrically connected to the second source electrode E2b of the second thin film transistor TFT2 through the hole of the first planarization layer 621. The second source electrode E2b of the second thin film transistor TFT2 may be electrically connected to the second capacitor electrode CAPE2 of the storage capacitor Cst.

The relay electrode RE may be disposed in the second metal layer on the first planarization layer 621 and may include a second metal. The second metal and the second metal layer may be referred to as a second source-drain metal and a second source-drain metal layer.

The second planarization layer 622 may be disposed on the first planarization layer 621. The second planarization layer 622 may be disposed on the relay electrode RE.

Referring to FIG. 6, the light emitting element unit may be disposed on the second planarization layer 622. The light emitting element ED may be formed on the second planarization layer 622. The light emitting element ED may include a pixel electrode PE, an intermediate layer EL, and a common electrode CE. The emission area of the light emitting element ED may be formed in an area in which the pixel electrode PE, the intermediate layer EL, and the common electrode CE overlap and contact each other.

The pixel electrode PE may be disposed on the second planarization layer 622. The pixel electrode PE may be electrically connected to the relay electrode RE through the hole of the second planarization layer 622.

The bank 631 may be disposed on the second planarization layer 622. The opening of the bank 631 may expose a portion of the pixel electrode PE to form the emission area. For example, the opening of the bank 631 may overlap a portion of the pixel electrode PE. The bank 631 may be formed of a material including a black pigment, or an organic material such as a benzocyclobutene resin, a polyimide resin, an acrylic resin, or a photosensitive polymer, but embodiments of the disclosure are not limited thereto.

The spacer 632 may be disposed on the bank 631. The spacer 632 may prevent or at least reduce damage due to contact of the fine metal mask used in the process. The spacer 632 may be formed of a material including a black pigment, or an organic material such as a benzocyclobutene resin, a polyimide resin, an acrylic resin, or a photosensitive polymer, but embodiments of the disclosure are not limited thereto.

The intermediate layer EL of the light emitting element ED may be disposed on a portion of the pixel electrode PE and the spacer 632. The common electrode CE may be disposed on the intermediate layer EL.

Referring to FIG. 6, the encapsulation unit may be disposed on the light emitting element unit and may be positioned on the common electrode CE. The encapsulation unit may include the encapsulation layer 310 formed on the common electrode CE.

The encapsulation layer 310 may prevent or at least reduce moisture or oxygen from penetrating into the light emitting element ED. For example, the encapsulation layer 310 may prevent or at least reduce moisture or oxygen from penetrating into the organic material included in the intermediate layer EL of the light emitting element ED. The encapsulation layer 310 may be formed of a single layer or multiple layers, but embodiments of the disclosure are not limited thereto.

Referring to FIG. 6, the encapsulation layer 310 may include a first inorganic encapsulation layer 311, a first organic encapsulation layer 312, and a second inorganic encapsulation layer 313 for example, but embodiments of the disclosure are not limited thereto. For example, the first inorganic encapsulation layer 311 and the second inorganic encapsulation layer 313 may include an inorganic layer, and the first organic encapsulation layer 312 may include an organic layer, but embodiments of the disclosure are not limited thereto.

The display panel 110 according to embodiments of the disclosure may include a touch sensor. In this case, the display panel 110 according to embodiments of the disclosure may include a touch sensor layer 320 formed on the encapsulation layer 310. The touch sensor layer 320 may be a touch unit.

Referring to FIG. 6, the touch sensor layer 320 may include a plurality of touch electrodes TE and may include a first touch metal TM1 and a second touch metal TM2 to form the plurality of touch electrodes TE. In embodiments of the disclosure, the layer on which the second touch metal TM2 is disposed may be referred to as a sensor metal layer, and the layer on which the first touch metal TM1 is disposed may be referred to as a bridge metal layer.

The touch sensor layer 320 may further include insulation layers, such as a touch buffer layer 321 on the encapsulation layer 310, a touch interlayer insulation layer 322 on the touch buffer layer 321, etc. Here, the touch buffer layer 321 may be omitted.

The first touch metal TM1 may be disposed between the touch buffer layer 321 and the touch interlayer insulation layer 322. The second touch metal TM2 may be disposed between the touch interlayer insulation layer 322 and the protective layer 323.

Each of the plurality of touch electrodes TE may be formed of the second touch metal TM2. Each of the plurality of touch electrodes TE may be a mesh type electrode having a plurality of openings, but embodiments of the disclosure are not limited thereto.

The plurality of touch electrodes TE may include a first touch electrode TE1 and a second touch electrode TE2. The second touch metal TM2 included in the first touch electrode TE1 may be electrically connected through the first touch metal TM1. For example, the second touch metals TM2 spaced apart from each other may be electrically connected by the first touch metal TM1 to constitute one first touch electrode TE1.

The first touch metals TM1 may be disposed on the buffer layer 321. The touch interlayer insulation layer 322 may be disposed on the first touch metals TM1. The second touch metal TM2 may be disposed on the touch interlayer insulation layer 322. Some of the second touch metals TM2 may be connected to the corresponding first touch metal TM1 through a hole in the insulation layer 322.

Referring to FIG. 6, the first touch metals TM1 and the second touch metals TM2 may be disposed not to overlap the light emitting element ED. The first touch metals TM1 and the second touch metals TM2 may overlap the bank 631.

The plurality of second touch metals TM2 may constitute one touch electrode TE. The plurality of second touch metals TM2 may be disposed in a mesh form and electrically connected to each other. A portion of the second touch metal TM2 and another portion of the second touch metal TM2 may be electrically connected through the first touch metal TM1 to constitute one touch electrode TE.

The components disposed in the normal area NA have been described above. The components disposed in the optical areas OA1 and OA2 are described below.

FIG. 7 is a view illustrating a pixel array layer 720 and a lower metal layer 710 according to embodiments of the disclosure.

Referring to FIG. 7, a pixel array layer 720 and a lower metal layer 710 disposed in the second optical area OA2 may be identified.

The lower metal layer 710 may be disposed on the substrate. The lower metal layer 710 may include a metal material. The lower metal layer 710 may be an opaque metal or a transparent metal.

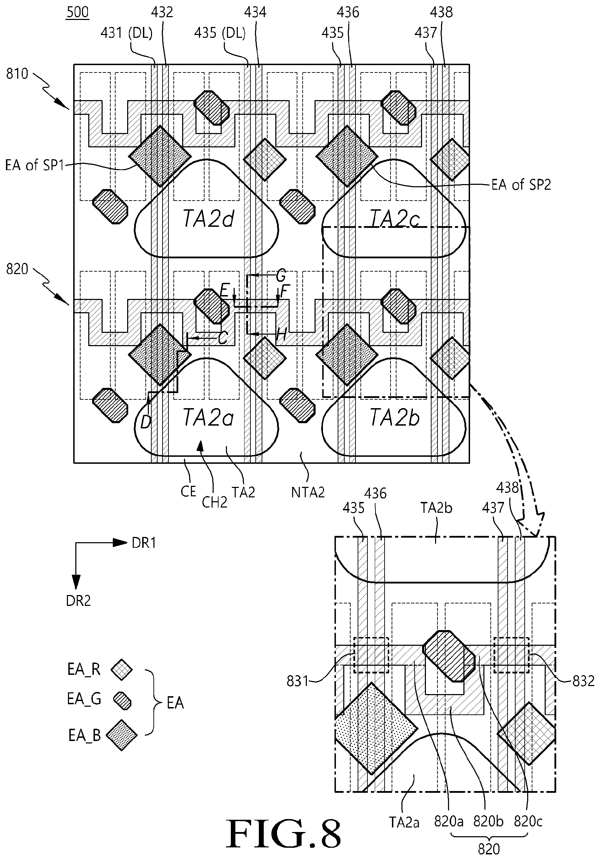

The lower metal layer 710 may include a plurality of metal patterns 711, 712, and 713. The plurality of metal patterns 711, 712, and 713 may be the same as the metal patterns illustrated in FIGS. 8 to 17. The plurality of metal patterns 711, 712, and 713 may have a line shape. The plurality of metal patterns 711, 712, and 713 may have a line shape and include a broken point. A detailed description of the plurality of metal patterns 711, 712, and 713 is given below.

The pixel array layer 720 may be disposed on the lower metal layer 710.

The pixel array layer 720 is a layer in which a plurality of subpixels SP are disposed. Referring to FIG. 7, the pixel array layer 720 may include a plurality of emission area EA. Referring to FIG. 7, the plurality of emission areas EA may include a first emission area EA of SP1 and a second emission area EA of SP2.

Referring to FIG. 7, the pixel array layer 720 may be disposed on the lower metal layer 710. Since the pixel array layer 720 is disposed on the lower metal layer 710, the lower portion of the pixel array layer 720 may be protected by the lower metal layer 710. For example, electric charges may be accumulated in a component disposed under the lower metal layer 710, and the electric charges may be prevented from affecting the pixel array layer 720.

Hereinafter, a plan view of the first area 500 illustrated in FIG. 5 is described with reference to FIG. 8.

FIG. 8 is a plan view illustrating a partial area 500 of an optical area OA2 in which metal patterns 810 and 820 are disposed according to embodiments of the disclosure.

Referring to FIG. 8, components for transistors may be disposed in the non-transmissive area NTA2, and the area in which components for transistors may be disposed is illustrated in a rectangular shape in the non-transmissive area NTA2.

Referring to FIG. 8, transmissive areas TA2 may be identified. A plurality of transmissive areas TA2 may be defined by the common electrode CE. The common electrode CE may include a plurality of common electrode holes CH2. Each of the areas in which the plurality of common electrode holes CH2 are disposed may be a transmissive area TA2.

The plurality of emission area EA may be disposed so as not to overlap the plurality of transmissive areas TA2. Referring to FIG. 8, the plurality of emission area EA may be disposed outside the transmissive area TA2.

Referring to FIG. 8, a plurality of data lines DL may be identified. The plurality of data lines DL may extend from the non-transmissive area NTA2 to the transmissive area TA2. The plurality of data lines DL may extend in the second direction DR2.

The second data line 432 may be disposed closer to the first data line 431 than the third data line 433. The fourth data line 434 may be disposed closer to the third data line 433 than the fifth data line 435. The sixth data line 436 may be disposed closer to the fifth data line 435 than the seventh data line 437.

The first data line 431, the second data line 432, the third data line 433, and the fourth data line 434 may extend from the fourth transmissive area TA2d to the first transmissive area TA2a. The first data line 431, the second data line 432, the third data line 433, and the fourth data line 434 may be disposed in the first transmissive area TA2a and the fourth transmissive area TA2d.

The fifth data line 435, the sixth data line 436, the seventh data line 437, and the eighth data line 438 may extend from the third transmissive area TA2c to the second transmissive area TA2b. The fifth data line 435, the sixth data line 436, the seventh data line 437, and the eighth data line 438 may be disposed in the second transmissive area TA2b and the third transmissive area TA2c.

In other words, referring to FIG. 8, each of the plurality of data lines DL may be disposed in the non-transmissive area NTA2, and the plurality of data lines DL may be disposed in at least one transmissive area TA2 of the plurality of transmissive areas TA2. The plurality of data lines DL may be disposed over the non-transmissive area NTA2 and at least one transmissive area TA2.

The plurality of data lines DL may extend from the non-transmissive area NTA2 to the transmissive area TA2. Each of the plurality of data lines DL may include several layers of metal line. In this case, the data line portion disposed in the transmissive area TA2 may include a transparent material. In this case, the transmittance of the transmissive area TA2 may be further enhanced. The data line portion disposed in the non-transmissive area NTA2 may include a transparent material or may include an opaque material. When the data line portion disposed in the non-transmissive area NTA2 includes a transparent material, the transmittance of the non-transmissive area NTA2 may be further enhanced.

Referring to FIG. 8, a plurality of data lines DL may be disposed to cross the metal patterns 810 and 820.

Referring to FIG. 8, the first metal pattern 810 and the second metal pattern 820 may be disposed in the non-transmissive area NTA2.

The first metal pattern 810 and the second metal pattern 820 illustrated in FIG. 8 may be included in the lower metal layer 710 illustrated in FIG. 7.

Referring to FIG. 8, the first metal pattern 810 and the second metal pattern 820 may extend in the first direction DR1.

Referring to FIG. 8, the first metal pattern 810 may be disposed to be spaced apart from the second metal pattern 820. The first metal pattern 810 may be disposed to be spaced apart from the second metal pattern 820 with the fourth transmissive area TA2d interposed therebetween. The first metal pattern 810 may be disposed to be spaced apart from the second metal pattern 820 with the third transmissive area TA2c interposed therebetween.

Referring to FIG. 8, the second metal pattern 820 may be disposed between the first transmissive area TA2a and the fourth transmissive area TA2d. Further, the second metal pattern 820 may be disposed between the second transmissive area TA2b and the third transmissive area TA2c. In other words, the second metal pattern 820 may extend in the first direction DR1 between the transmissive areas TA2.

Referring to FIG. 8, the metal patterns 810 and 820 may overlap a plurality of data lines DL.

Referring to FIG. 8, the second metal pattern 820 may overlap the fifth data line 435 and the sixth data line 436 in the first crossing area 831.

Referring to FIG. 8, the second metal pattern 820 may overlap the seventh data line 437 and the eighth data line 438 in the second crossing area 832.

Referring to FIG. 8, the first metal pattern 810 and the second metal pattern 820 may have a line shape. The first metal pattern 810 and the second metal pattern 820 may have a curved line shape.

Referring to FIG. 8, the first metal pattern 810 and the second metal pattern 820 may extend in the first direction DR1 while a predetermined pattern is repeated. The first metal pattern 810 and the second metal pattern 820 may have a line shape without a broken point.

Referring to FIG. 8, the second metal pattern 820 may include a first pattern portion 820a, a second pattern portion 820b, and a third pattern portion 820c.

The first pattern portion 820a may be disposed closer to the third transmissive area TA2c than the second pattern portion 820b. The first pattern portion 820a may extend in the first direction DR1, and the first pattern portion 820a may overlap the fifth data line 435. The first pattern portion 820a may also overlap the sixth data line 436.

The second pattern portion 820b may be disposed closer to the second transmissive area TA2b than the first pattern portion 820a. The second pattern portion 820b may have a "U" shape. The second pattern portion 820b may be a portion connecting the first pattern portion 820a and the third pattern portion 820c.

The third pattern portion 820c may be disposed closer to the third transmissive area TA2c than the second pattern portion 820b. The third pattern portion 820c may extend in the first direction DR1, and the third pattern portion 820c may overlap the seventh data line 437. The third pattern portion 820c may also overlap the eighth data line 438.

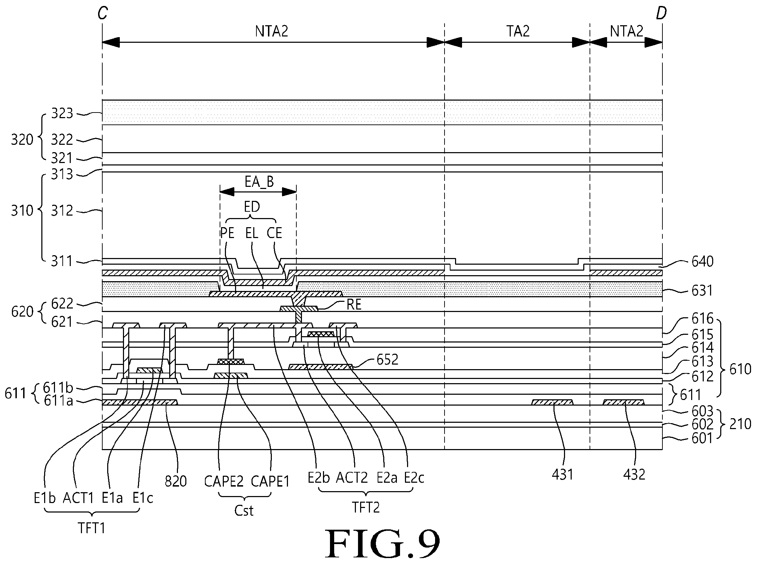

Referring to FIG. 8, a C-D area illustrated in a plan view of the display panel 110 may be identified. The C-D area is an area crossing the second metal pattern 820, the blue emission area EA_B, the second data line 432, and the first data line 431. A cross-sectional view of the display panel 110 including the metal patterns 810 and 820 is described with reference to FIG. 9.

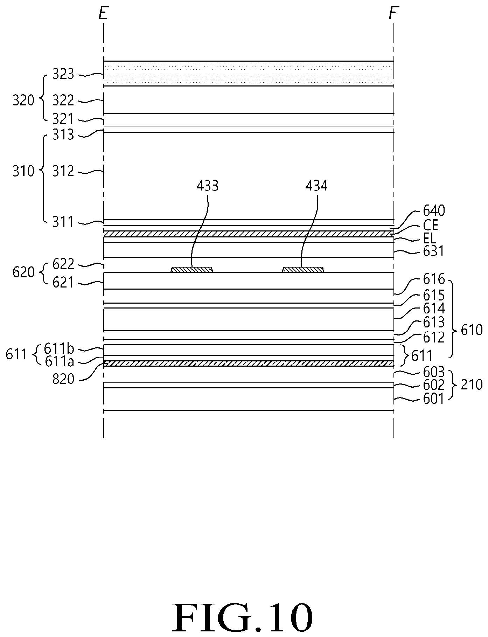

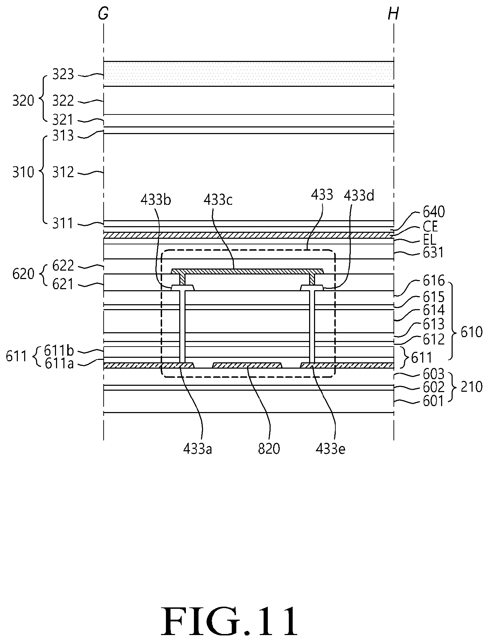

Referring to FIG. 8, an E-F area and a G-H area illustrated in a plan view of the display panel 110 may be identified. The E-F area is an area crossing the second metal pattern 820, the third data line 433, and the fourth data line 434. The G-H area is an area crossing the second metal pattern 820 and the third data line 433. Referring to FIGS. 10 and 11, a cross-sectional view of an area where the metal pattern overlaps the data line DL is described. The description continues below.

FIG. 9 is a cross-sectional view of area C-D of FIG. 8 according to one embodiment.

Referring to FIG. 9, a substrate 210, a plurality of insulation layers 610, planarization layers 620, an encapsulation layer 310, and a touch sensor layer 320 are illustrated, which are the same as those illustrated in FIG. 6. Among the components illustrated in FIG. 9, descriptions of the same components as those illustrated in FIG. 6 may be omitted.

The following description focuses primarily on the cross-sectional view of FIG.9 but, as necessary, FIG. 8 is also referred to.

Referring to FIG. 9, the substrate 210 may be disposed in contact with the first buffer layer 611.

Electric charges may be accumulated in a portion where the substrate 210 and the first buffer layer 611 contact each other.

When electric charges are accumulated in the contact portion between the substrate 210 and the first buffer layer 611, the corresponding electric charges may affect the first active layer ACT1 and the second active layer ACT2.

Referring to FIG. 9, the second metal pattern 820 may be disposed between the first buffer layer 611 and the substrate 210.

As the second metal pattern 820 is positioned between the first buffer layer 611 and the substrate 210, it is possible to prevent or at least reduce electric charges from affecting the first active layer ACT1.

Since the second metal pattern 820 may prevent or at least reduce electric charges from affecting the first active layer ACT1, the upper electric charge of the second metal pattern 820 may be smaller than the lower electric charge of the second metal pattern 820.

The second metal pattern 820 may be disposed under the first active layer ACT1.

A portion of the second metal pattern 820 may be disposed to completely overlap the first active layer ACT 1. In other words, as a portion of the second metal pattern 820 completely overlaps the first active layer ACT1, the second metal pattern 820 may more effectively block electric charges from affecting the first active layer ACT1.

An area of the first active layer ACT1 may be larger than an area of the second active layer ACT2. In this case, the influence of electric charges on the first active layer ACT1 may be larger than the influence of electric charges on the second active layer ACT2. In other words, when the second metal pattern 820 is disposed under the first active layer ACT1, the subpixel SP including the first active layer ACT1 may be more stably driven. In this case, the first active layer ACT1 may be formed of low-temperature polysilicon, and the second active layer ACT2 may be formed of an oxide semiconductor, but the first active layer ACT1 and the second active layer ACT2 are not limited thereto.

Meanwhile, the second metal pattern 820 may be disposed in the non-transmissive area NTA2. The non-transmissive area NTA2 may have a lower transmittance than that of the transmissive area TA2. The optical device is disposed in the optical areas OA1 and OA2, and as the transmittance of the optical areas OA1 and OA2 increases, the sensing performance of the optical device may be further enhanced. Therefore, it is necessary to increase the transmittance of the transmissive area TA2 and also to increase the transmittance of the non-transmissive area NTA2.

The second metal pattern 820 may be an opaque metal, but when the second metal pattern 820 is a transparent metal, the transmittance of the non-transmissive area NTA2 may be further enhanced.

Referring to FIGS. 8 and 9, the second metal pattern 820 may have a line shape including a zigzag pattern. In this case, the second metal pattern 820 may overlap the first active layer ACT1 included in each of the plurality of subpixels. In other words, the second metal pattern 820 may extend in the first direction DR1 while having a line shape including a zigzag pattern, and in this case, the second metal pattern 820 may be disposed to pass below the first active layer ACT1.

Referring to FIG. 8, the second metal pattern 820 may have a line shape and may extend in the first direction DR1. In this case, the second metal pattern 820 may extend in the first direction DR1 to the normal area NA illustrated in FIG. 6. In this case, the first shield metal 651 illustrated in FIG. 6 may be a portion of the second metal pattern 820, and the first shield metal 651 may be a transparent metal. However, unlike this, the second metal pattern 820 may be disposed only in the optical areas OA1 and OA2 while being spaced apart from the first shield metal 651 illustrated in FIG. 6. In this case, the second metal pattern 820 illustrated in FIG. 9 may be a transparent metal, and the first shield metal 651 illustrated in FIG. 6 may be disposed on the same layer as the second metal pattern 820 but may be an opaque metal.

Meanwhile, referring to FIG. 9, the second metal pattern 820 may be disposed on the same layer as the layer on which a portion of the data line DL is disposed. Referring to FIG. 9, the second metal pattern 820 may be disposed on the same layer as a portion of the first data line 431 and a portion of the second data line 432.

Referring to FIG. 9, the first data line 431 may be disposed in the transmissive area TA2. In this case, the first data line 431 may include a transparent material. When the first data line 431 includes a transparent material, the transmittance of the transmissive area TA2 may be further enhanced.

The first data line 431 may be disposed in the transmissive area TA2, and the common electrode CE may not be disposed in the transmissive area TA2. Accordingly, a portion of the first data line 431 may not overlap the common electrode CE.

Referring to FIG. 9, the second data line 432 may be disposed in the non-transmissive area NTA2. In this case, the second data line 432 may be an opaque metal or a transparent metal. When the second data line 432 is a transparent metal, the transmittance of the non-transmissive area NTA2 may be further enhanced.

FIG. 10 is a cross-sectional view of area E-F of FIG. 8 according to one embodiment.

Referring to FIG. 8, the E-F area is an area that cuts the second metal pattern 820, the third data line 433, and the fourth data line 434. A cross-sectional view of the E-F area is illustrated in FIG. 10.

Referring to FIG. 10, the second metal pattern 820 may be disposed on the substrate 210.

Referring to FIG. 10, the second metal pattern 820 may be disposed to be spaced apart from the data lines in the E-F area.

Referring to FIG. 10, data lines may be disposed on the second planarization layer 622.

Referring to FIG. 8, since the second metal pattern 820 extends in the first direction DR1 and the data line DL extends in the second direction DR2, the second metal pattern 820 and the data line DL may cross each other. When the second metal pattern 820 and the data line DL cross each other, the second metal pattern 820 may overlap the data line DL. When the second metal pattern 820 is disposed on a specific layer, the data line DL may be disposed to overlap the second metal pattern 820 through metal lines disposed on a plurality of layers. Further, when the plurality of data lines DL are disposed on a specific layer, the second metal pattern 820 may be disposed to overlap the data line DL through the metal line disposed on the plurality of layers.

Hereinafter, a structure in which the data line DL includes metal line portions disposed on the plurality of layers, and the data line DL overlaps the second metal pattern 820 is described.

FIG. 11 is a cross-sectional view of area G-H of FIG. 8 according to one embodiment.

Referring to FIG. 8, the G-H area is an area that cuts the third data line 433 and the second metal pattern 820. FIG. 11 is a cross-sectional view of the G-H area.

Referring to FIG. 11, the third data line 433 may include a first line portion 433a, a second line portion 433b, a third line portion 433c, a fourth line portion 433d, and a fifth line portion 433e. The third data line 433 may include a plurality of line portions, which may be referred to as a jumping line structure.

The first line portion 433a may be disposed on the substrate 210. The first line portion 433a may be disposed on the same layer as the layer on which the second metal pattern 820 is disposed. The first line portion 433a may be a transparent metal or an opaque metal.

A portion of the second line portion 433b may be disposed on the first planarization layer 621. A portion of the second line portion 433b may be electrically connected to the first line portion 433a through a contact hole formed in the plurality of insulation layers 610. The second line portion 433b may be an opaque metal. The second line portion 433b may include the first source-drain metal illustrated in FIG. 6. The second line portion 433b may overlap the first line portion 433a and the third line portion 433c.

A portion of the third line portion 433c may be disposed on the second planarization layer 622. A portion of the third line portion 433c may be electrically connected to the second line portion 433b through a contact hole formed in the second planarization layer 622. The third line portion 433c may be an opaque metal. The third line portion 433c may include the second source-drain metal illustrated in FIG. 6. A portion of the third line portion 433c may be disposed to overlap the second metal pattern 820. The third line portion 433c may extend from a portion connected to the second line portion 433b to a portion connected to the fourth line portion 433d, and the extending third line portion 433c may be disposed to overlap the second metal pattern 820.

A portion of the fourth line portion 433d may be disposed on the first planarization layer 621. A portion of the fourth line portion 433d may be electrically connected to the third line portion 433c through a contact hole formed in the plurality of insulation layers 610. The fourth line portion 433d may be an opaque metal. The fourth line portion 433d may include the first source-drain metal illustrated in FIG. 6. The fourth line portion 433d may overlap the third line portion 433c and the fifth line portion 433e.

The fifth line portion 433e may be disposed on the substrate 210. The fifth line portion 433e may be disposed on the same layer as the layer on which the second metal pattern 820 is disposed. The fifth line portion 433e may be a transparent metal or an opaque metal.

The first line portion 433a and the fifth line portion 433e may be a transparent metal or an opaque metal. The first line portion 433a and the fifth line portion 433e are disposed in the non-transmissive area NTA2, and the first line portion 433a and the fifth line portion 433e may be a transparent metal. In this case, the transmittance of the non-transmissive area NTA2 may be further enhanced.

The characteristics of the above-described third data line 433 are all applicable to the data lines DL included in the plurality of data lines DL. It has been described that the third data line 433 includes the first line portion 433a to the fifth line portion 433e.

However, the third data line 433 may not include the third line portion 433c and the fourth line portion 433d. In this case, the second line portion 433b may be disposed in a similar shape to the third line portion 433c, and the second line portion 433b may be disposed on the first planarization layer 621, electrically connected to the first line portion 433a and the fifth line portion 433e, and may overlap the second metal pattern 820.

Further, when an additional planarization layer is disposed on the second planarization layer 622, the third data line 433 may further include an additional line portion in addition to the fifth line portion 433e.

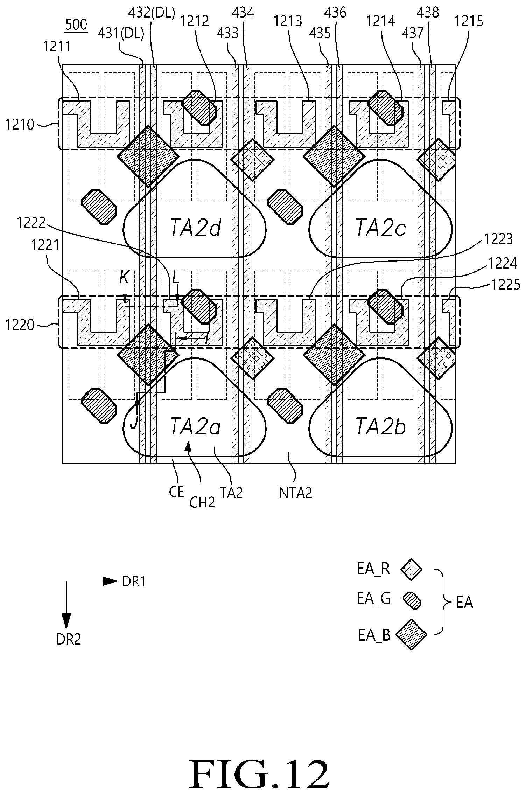

FIG. 12 is a plan view illustrating a partial area 500 of an optical area OA2 in which metal patterns 1210 and 1220 are disposed according to embodiments of the disclosure.

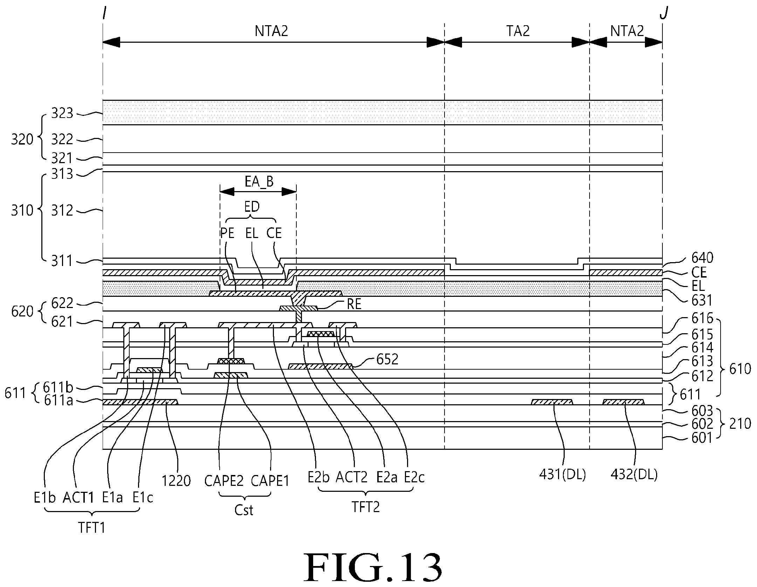

FIG. 13 is a cross-sectional view of area I-J of FIG. 12 according to one embodiment.

Unlike the metal patterns 810 and 820 illustrated in FIG. 8, the metal patterns 1210 and 1220 illustrated in FIG. 12 may include at least one broken point.

Referring to FIG. 12, the first metal pattern 1210 may include a plurality of island metals 1211, 1212, 1213, 1214, and 1215. For example, the first metal pattern 1210 may include a first island metal 1211, a second island metal 1212, a third island metal 1213, a fourth island metal 1214, and a fifth island metal 1215. The second metal pattern 1220 may include a sixth island metal 1221, a seventh island metal 1222, an eighth island metal 1223, a ninth island metal 1224, and a tenth island metal 1225.

At least one data line DL may be disposed between the island metals. Referring to FIG. 12, two data lines DL may be disposed between island metals.

Referring to FIG. 12, the first data line 431 and the second data line 432 may be disposed between the first island metal 1211 and the second island metal 1212. The third data line 433 and the fourth data line 434 may be disposed between the second island metal 1212 and the third island metal 1213.

Referring to FIG. 12, the first data line 431 and the second data line 432 may be disposed between the sixth island metal 1221 and the seventh island metal 1222. The third data line 433 and the fourth data line 434 may be disposed between the seventh island metal 1222 and the eighth island metal 1223. No repetitive description is presented below.

Referring to FIG. 12, the I-J area may be identified. FIG. 13 is a cross-sectional view of the I-J area. The components illustrated in FIG. 13 may be the same as those illustrated in FIG. 9. Among the components illustrated in FIG. 13, descriptions of the same components as those illustrated in FIG. 9 may be omitted. Referring to FIG. 13, like the second metal pattern 820 of FIG. 9, the second metal pattern 1220 of FIG. 13 may also be disposed under the first active layer ACT1. In this case, the second metal pattern 1220 may be disposed in the non-transmissive area NTA2. The second metal pattern 1220 may be a transparent metal, and when the second metal pattern 1220 is a transparent metal, the transmittance of the non-transmissive area NTA2 may be further enhanced.

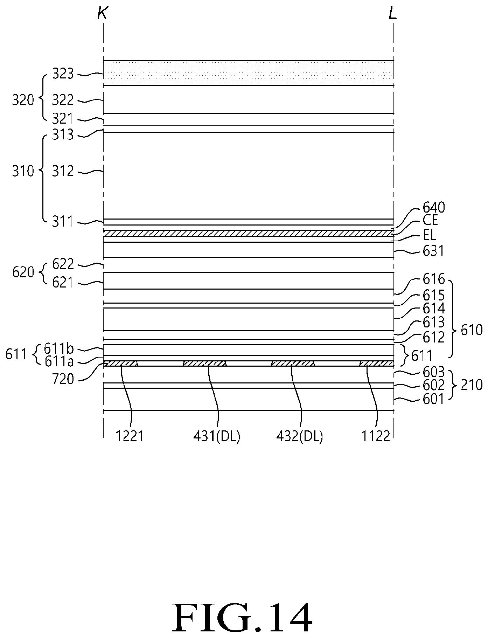

Referring to FIG. 12, the K-L area may be identified. The K-L area is an area that cuts the sixth island metal 1221, the first data line 431, the second data line 432, and the seventh island metal 1222. FIG. 14 is a cross-sectional view of the K-L area.

FIG. 14 is a cross-sectional view of area K-L of FIG. 12.

Referring to FIG. 14, the sixth island metal 1221 may be disposed on the same layer as the first data line 431 and the second data line 432. With respect to the horizontal direction, the sixth island metal 1221 may be disposed to be spaced apart from the first data line 431 and the second data line 432.

Referring to FIG. 14, the seventh island metal 1222 may be disposed on the same layer as the first data line 431 and the second data line 432. With respect to the horizontal direction, the seventh island metal 1222 may be disposed to be spaced apart from the first data line 431 and the second data line 432.

Referring to FIGS. 12 and 14, the metal patterns 1210 and 1220 may include a plurality of broken points. Therefore, the first metal pattern 1210 may include a plurality of island metals 1211, 1212, 1213, 1214, and 1215, and the second metal pattern 1220 may also include a plurality of island metals 1221, 1222, 1223, 1224, and 1225.

When the metal pattern is disposed as an island metal, the metal pattern may not overlap the data line DL. The metal pattern may extend in the first direction DR1, the data line DL may extend in the second direction DR2, and at least a portion of the metal pattern may include a shape which is broken at a point where the metal pattern and the data line DL cross each other. Accordingly, the data line DL may be disposed on the same layer as the metal pattern.

In other words, the metal pattern disposed in the non-transmissive area NTA2 may be a transparent metal, and accordingly, the transmittance of the non-transmissive area NTA2 may be enhanced. Further, the data line DL disposed in the non-transmissive area NTA2 may be a transparent metal, and in this case, the transmittance of the non-transmissive area NTA2 may be further enhanced.

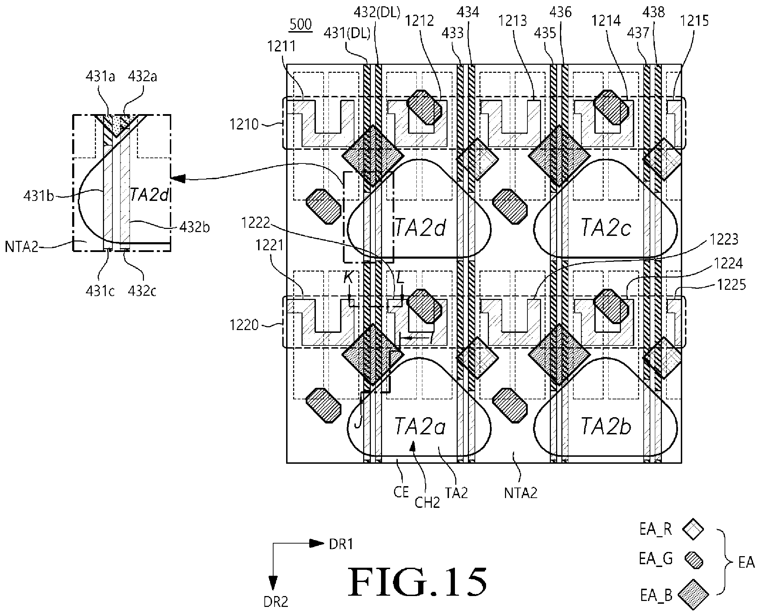

However, it may be designed that only a portion of the data line DL is a transparent metal, and the other portion includes an opaque metal. This is described with reference to FIG. 15.

FIG. 15 is a plan view illustrating an optical area where a metal pattern is disposed according to embodiments of the disclosure.

Referring to FIG. 15, the metal patterns 1210 and 1220 illustrated in FIG. 15 are the same as the metal pattern illustrated in FIG. 13.

Referring to FIG. 15, a plurality of data lines DL may include transparent line portions 431b and 432b and opaque line portions 431a, 431c, 432a and 432c.

The transparent line portions 431b and 432b may be disposed in the transmissive area TA2. The transparent line portions 431b and 432b may be disposed on the same layer as the metal patterns 1210 and 1220.

The opaque line portions 431a, 431c, 432a and 432c may be disposed in the non-transmissive area NTA2. The opaque line portions 431a, 431c, 432a and 432c may be disposed on a higher layer than the layer on which the metal patterns 1210 and 1220 are disposed. The opaque line portions 431a, 431c, 432a, and 432c may be connected to the transparent line portions 431b and 432b, and the opaque line portions 431a, 431c, 432a, and 432c may be connected to the transparent line portions 431b and 432b through the jumping line structure illustrated in FIG. 11.

For example, the transparent line portions 431b and 432b may be disposed in the transmissive area TA2 and may be disposed on the same layer as the metal patterns 1210 and 1220. The opaque line portions 431a, 431c, 432a, and 432c may be positioned on a higher layer than the transparent line portions 431b and 432b, and for example, the opaque line portions 431a, 431c, 432a, and 432c may be disposed on the first planarization layer 621 or the second planarization layer 622. The opaque line portions 431a, 431c, 432a and 432c may include a first source-drain metal or a second source-drain metal.

The opaque line portions 431a, 431c, 432a and 432c may be disposed on the first planarization layer 621 or the second planarization layer 622 and may extend from the non-transmissive area NTA2 toward the transmissive area TA2. In this case, the opaque line portions 431a, 431c, 432a, and 432c may be connected to the transparent line portions 431b and 432b through contact holes formed in the insulation layers, and the corresponding transparent line portions 431b and 432b may extend to the transmissive area TA2.

Referring to FIG. 15, the opaque line portions 431a, 431c, 432a and 432c may be disposed only in the non-transmissive area NTA2. The transparent line portions 431b and 432b may be disposed in the transmissive area TA2 and may extend to a portion of the non-transmissive area NTA2. When the opaque line portions 431a, 431c, 432a, and 432c extend to a portion of the transmissive area TA2, the transmittance of the transmissive area TA2 may be decreased. To prevent this, the transparent line portions 431b and 432b may extend from the transmissive area TA2 to a portion of the non-transmissive area NTA2.

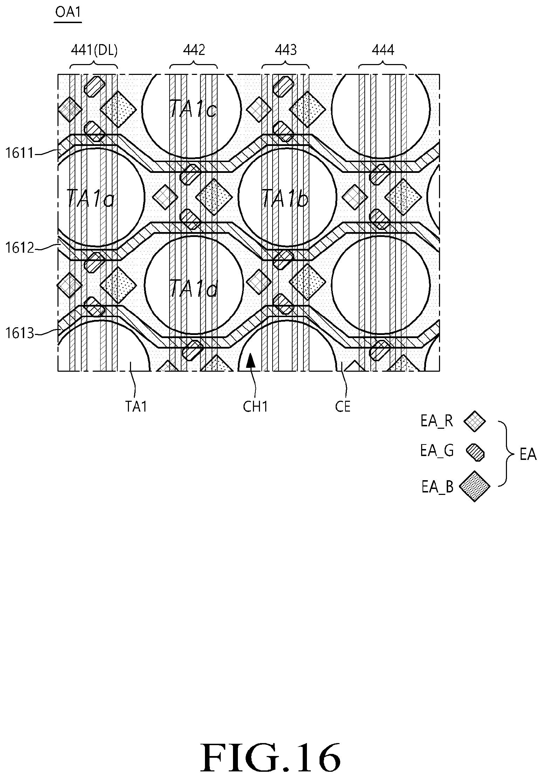

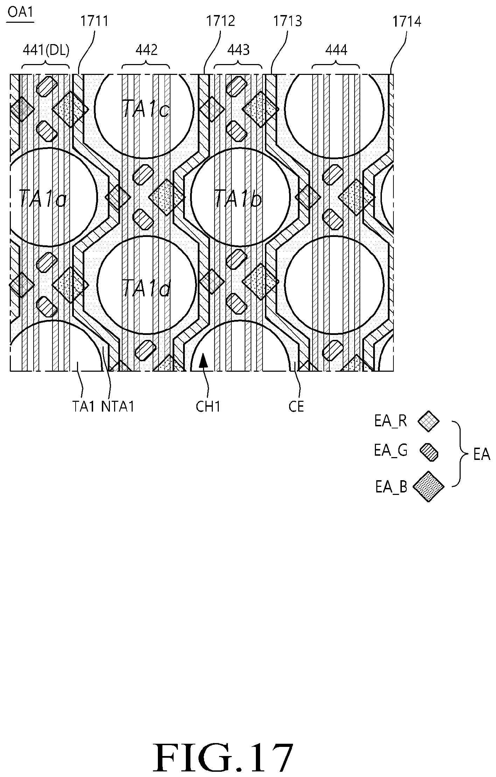

FIGS. 16 and 17 are plan views illustrating an optical area where a metal pattern is disposed according to embodiments of the disclosure.

Referring to FIG. 16, the first optical area OA1 may include a plurality of transmissive areas TA1 and a non-transmissive area NTA1.

Referring to FIG. 16, the plurality of transmissive areas TA1 may include a first transmissive area TA1a, a second transmissive area TA1b, a third transmissive area TA1c, and a fourth transmissive area TA1d.

The plurality of transmissive areas TA1 may correspond to the common electrode hole CH1. The common electrode hole CH1 is an area where a portion of the common electrode CE is removed.

The second transmissive area TA1b may be disposed in line with the first transmissive area TA1a in the first direction DR1.

The third transmissive area TA1c may be disposed in line with the fourth transmissive area TA1D in the second direction DR2. The third transmissive area TA1c may be positioned at a right upper end of the first transmissive area TA1a. The third transmissive area TA1c may be positioned at a left upper end of the second transmissive area TA1b.

The fourth transmissive area TA1D may be positioned at a right lower end of the first transmissive area TA1a. The fourth transmissive area TA1d may be positioned at a left lower end of the second transmissive area TA1b.

The emission area EA may be positioned in the non-transmissive area NTA1. The emission area EA may be disposed between the transmissive areas TA1.

The emission area EA may be positioned between the transmissive areas TA1 disposed in a row in the first direction DR1.

The emission area EA may be positioned between the transmissive areas TA1 disposed in a row in the second direction DR2.

The metal patterns 1611, 1612, and 1613 may be disposed in the non-transmissive area NTA1.

The metal patterns 1611, 1612, and 1613 may extend in the first direction DR1.

The metal patterns 1611, 1612, and 1613 may not be disposed in the transmissive area TA1.

The metal patterns 1611, 1612, and 1613 may have a curved line shape.

For example, the upper end of the first transmissive area TA1a may be disposed relatively higher than the lower end of the third transmissive area TA1c. In this case, the first metal pattern 1611 may extend to pass above the first transmissive area TA1a. The first metal pattern 1611 may extend in the first direction DR1, and the first metal pattern 1611 may extend to pass below the third transmissive area TA1c. Referring to FIG. 16, it may be identified that the first metal pattern 1611 has a curved line shape.

The plurality of data lines DL may extend from the non-transmissive area NTA1 to the transmissive area TA1.

The plurality of data lines DL may extend in the second direction DR2.

The first data line group 441 may be disposed to pass through the first transmissive area TA1a. The first data line group 441 may include four data lines.

The second data line group 442 may be disposed to pass through the third transmissive area TA1c and the fourth transmissive area TA1d. The second data line group 442 may include four data lines.

The third data line group 443 may be disposed to pass through the second transmissive area TA1b. The third data line group 443 may include four data lines.

The fourth data line group 444 may be disposed to pass through the transmissive areas TA1. The fourth data line group 444 may include four data lines.

Referring to FIG. 16, the metal patterns 1611, 1612, and 1613 may extend in the first direction DR1, and the plurality of data lines DL may extend in the second direction DR2. Accordingly, the metal patterns 1611, 1612, and 1613 may overlap the plurality of data lines DL. Alternatively, the metal patterns 1611, 1612, and 1613 may cross the plurality of data lines DL. The data line DL may have a jumping line structure illustrated in FIG. 11. In an area where the data line DL overlaps the metal pattern, a portion of the data line may be disposed on the metal pattern.

The metal patterns 1611, 1612, and 1613 may be transparent metal. In this case, the transmittance of the non-transmissive area NTA1 may be further enhanced.

The plurality of data lines DL may include a transparent metal. When the plurality of data lines DL include a transparent metal, transmittance of the transmissive area TA1 and the non-transmissive area NTA1 may be enhanced.

Referring to FIG. 17, the metal patterns 1711, 1712, 1713, and 1714 may extend in the second direction DR2.

Referring to FIG. 17, the first metal pattern 1711 may be disposed between the first data line group 441 and the second data line group 442.

Referring to FIG. 17, the second metal pattern 1712 may be disposed between the second data line group 442 and the third data line group 443.

Referring to FIG. 17, the third metal pattern 1713 may be disposed between the third data line group 443 and the fourth data line group 444.

Referring to FIG. 17, the fourth metal pattern 1714 may be disposed on the right side of the fourth data line group 444.

The plurality of data lines DL may extend in the second direction DR2.

The plurality of data lines DL may be disposed to be spaced apart from the metal patterns 1711, 1712, 1713, and 1714.

The metal patterns 1711, 1712, 1713, and 1714 may include a transparent material. In this case, the transmittance of the non-transmissive area NTA1 may be enhanced.

The plurality of data lines DL may include a transparent material. In this case, the transmittance of the non-transmissive area NTA1 and the transmissive area TA1 may be enhanced.

The metal patterns 1611, 1612, and 1613 illustrated in FIG. 16 and the metal patterns 1711, 1712, 1713 and 1714 illustrated in FIG.17 may be disposed between the first buffer layer 611 and the substrate 210 illustrated in FIG. 9.

Some of the data lines DL illustrated in FIG. 16 may be disposed between the first buffer layer 611 and the substrate 210 illustrated in FIG. 9.

The plurality of data lines DL illustrated in FIG. 17 may be disposed between the first buffer layer 611 and the substrate 210 illustrated in FIG. 9.

The above description has been presented to enable any person skilled in the art to make and use the technical idea of the disclosure, and has been provided in the context of a particular application and its requirements.

## Claims

1. A display device, comprising:
a substrate (210) including a display area (DA) configured to display an image, the display area (DA) including a normal area (NA) and an optical area (OA2), wherein the optical area (OA2) includes a plurality of transmissive areas (TA2), and wherein the optical area (OA2) further includes a non-transmissive area (NTA2) that is outside the plurality of transmissive areas (TA2);
a metal pattern (820) on the substrate (210), wherein the metal pattern (280) is disposed in the non-transmissive area (NTA);
a first data line (DL) on the substrate (210), wherein the first data line (DL) extends over the non-transmissive area (NTA) and at least one of the plurality of transmissive areas (TA2); and
a first active layer (ACT1) on the metal pattern (820) and overlapping the metal pattern (820).

2. The display device of claim 1, wherein the first data line (DL) extends from a first transmissive area (TA2) of the plurality of transmissive areas to the non-transmissive area (NTA2), and
wherein a portion of the first data line (DL) that is positioned in the first transmissive area (TA2) includes a transparent material, and a portion of the first data line (DL) positioned in the non-transmissive area (NTA2) includes the transparent material or an opaque material.

3. The display device of claim 1 or 2, wherein the first data line (DL) includes:
a first line portion (433a) on a same layer as the metal pattern (820), extending from a first transmissive area of the plurality of transmissive areas (TA2) to the non-transmissive area (NTA2), and including the transparent material;
a second line portion (433c) on the metal pattern (820), electrically connected to the first line portion (433a), and including an opaque material; and
a third line portion (433e) on the same layer as the metal pattern (820), extending from the non-transmissive area (NTA2) to a second transmissive area of the plurality of transmissive areas (TA2), electrically connected to the second line portion (433c), and including the transparent material.

4. The display device of claim 3, further comprising:
an optical device under the substrate (210), the optical device having at least a portion disposed in the first transmissive area (TA2),
preferably wherein the first line portion (433a) and the third line portion (433e) overlap the optical device.

5. The display device of any one of the preceding claims, wherein the metal pattern (1210) includes:
a first island metal (1221) on a same layer as the first data line (DL); and
a second island metal (1222) on the same layer as the first data line (LD), the second island metal (1222) spaced apart from the first island metal (1221) with the first data line (431) interposed therebetween.

6. The display device of claim 5, wherein the first data line (LD) extends from the non-transmissive area (NTA2) to a transmissive area of the plurality of transmissive areas (TA2), passes through an area between the first island metal (1221) and the second island metal (1222), and includes the transparent material.

7. The display device of claim 5 or 6, wherein the first data line (DL) includes:
a transparent line portion (431b) in a first transmissive area of the plurality of transmissive areas (TA2), and including the transparent material; and
an opaque line portion (431a) in the non-transmissive area (NTA2), electrically connected to the transparent line portion (431b), and including an opaque material,
preferably wherein the transparent line portion (431b) extends from the first transmissive area (TA2) to a portion of the non-transmissive area (NTA2).

8. The display device of any one of claims 1 to 4, wherein the metal pattern (1711) and the first data line (DL) are spaced apart from each other, and the metal pattern (1711) and the first data line (DL) extend in a same direction.

9. The display device of any one of claims 1 to 7, wherein the metal pattern (820) extends in a first direction (DR1) and the first data line (DL) extends in a second direction (DR2) that is different from the first direction (DR1), and
wherein the metal pattern (820) overlaps the first data line (DL), and both or either of the metal pattern (820) and the first data line (DL) includes a transparent material.

10. The display device of claim 1, wherein:
an amount of electric charge under the metal pattern (820) is larger than an amount of electric charge above the metal pattern (820), and/or
the display device further comprises a second active layer (ACT2) including a material different from a material included in the first active layer (ACT1), wherein an area of the first active layer (ACT1) is larger than an area of the second active layer (ACT2).

11. The display device of any one of the preceding claims, comprising:
a first subpixel (SP) on the substrate (210) and disposed in the non-transmissive area (NTA2), the first subpixel (SP) including a first transistor (TFT1), wherein the first data line (DL) is connected to the first subpixel (SP);
a second subpixel (SP) on the substrate (210) and disposed in the non-transmissive area (NTA2), the second subpixel (SP) including a second transistor (TFT1); and
a second data line (DL) connected to the second subpixel (SP), the second data line (DL) extending over the non-transmissive area (NTA) and at least one of the plurality of transmissive areas (TA2),
wherein the metal pattern (820) is positioned under the first transistor (TFT1) and the second transistor (TFT1), overlapping at least a portion of the first transistor (TFT1) and at least a portion of the second transistor (TFT1),
preferably wherein the metal pattern (820) has a line shape.

12. The display device of any one of the preceding claims, wherein the metal pattern (820) includes a transparent material and/or wherein the first data line (DL) and, if applicable, the second data line (DL) include a same transparent material as the metal pattern (820).

13. The display device of any one of the preceding claims,
wherein the metal pattern (820) extends to the normal area (NA), or
wherein the display device further comprises a further metal pattern (651) on a same layer as the metal pattern (820), in the normal area (NA), and including an opaque material.

14. The display device of any one of the preceding claims,
wherein the metal pattern (820) has a curved line shape or meandering line shape, and/or
wherein the metal pattern (820; 1220) has either a line shape without a broken point or a line shape with at least one broken point.

15. The display device of any one of claims 11 to 14 when dependent on claim 11, wherein the metal pattern (1220) crosses the first data line (431) and the second data line (432) in a first area and a second area, respectively,
wherein the first data line (431) includes a first opaque line portion (431a) in the first area and a first transparent line portion (431b) in an area other than the first area, wherein the first opaque line portion (431a) and the first transparent line portion (431b) are electrically connected to each other through a first contact hole in an insulation layer that is between the first opaque line portion (431a) and the first transparent line portion (431b), and
wherein the second data line (432) includes a second opaque line portion (432a) in the second area and a second transparent line portion (432b) in an area other than the second area, wherein the second opaque line portion (432a) and the second transparent line portion (432b) are electrically connected to each other through a second contact hole in the insulation layer that is between the second opaque line portion (432a) and the second transparent line portion (432b).
